# EUROPEAN PATENT APPLICATION

(11) **EP 4 567 438 A1**
(43) Date of publication of application: **11.06.2025**
(21) Application number: 23850174.6
(22) Date of filing: 04.08.2023
(51) Int. Cl.: G01R 27/02, G01R 31/00

(54) **ELECTRICAL CONDUCTIVITY TESTING METHOD, PEELING METHOD, ELECTRICALLY PEELABLE ADHESIVE LAYER, AND ADHESIVE SHEET**

(30) Priority: 05.08.2022 JP 2022125642
(71) Applicant: NITTO DENKO CORPORATION, Ibaraki-shi Osaka 567-8680 (JP)
(72) Inventor: KURODA Tomoharu, Ibaraki-shi, Osaka 567-8680 (JP); MIZUHARA Ginji, Ibaraki-shi, Osaka 567-8680 (JP)
(74) Representative: Gill Jennings & Every LLP
(86) International application number: PCT/JP2023/028567
(87) International publication number: WO 2024/029621

(57) **Abstract**

To efficiently determine an electrically conductive property of an inspection target. In an electrical conductivity inspection method, an inspection target (an electrical conductor 3 or an insulator 4) and a fixing member 2 are joined together using an electrically debondable pressure-sensitive adhesive layer 1 capable of joining the inspection target and the fixing member 2, a voltage is applied to the inspection target and the electrically debondable pressure-sensitive adhesive layer 1, and an electrically conductive property of the inspection target is determined according to a joining state between the inspection target and the fixing member 2 after the voltage is applied.

## Description

### TECHNICAL FIELD

The present invention relates to an electrical conductivity inspection method, a separation method, an electrically debondable pressure-sensitive adhesive layer, and a pressure-sensitive adhesive sheet.

### BACKGROUND ART

In recent years, with an increasing demand for various electronic components, various methods for inspecting electronic components have been proposed. For example, as a method of inspecting a capacitor, which is a type of electronic component, there is a method in which a current value or a resistance value of each capacitor is measured and compared with a threshold value to determine whether the capacitor is good or bad (see, for example, Patent Literatures 1 and 2).

In addition, a method for improving the efficiency of inspection by collectively inspecting a plurality of electronic components has been proposed (see, for example, Patent Literature 3). In this method, a plurality of electrically conductive pieces corresponding to an electronic component are fixed with an electrically conductive pressure-sensitive adhesive, electrodes of the electrically conductive pieces are brought into contact with the pressure-sensitive adhesive, and a current is passed through each electrically conductive piece through the pressure-sensitive adhesive. Accordingly, all the electrically conductive pieces on the pressure-sensitive adhesive can be inspected simultaneously and collectively.

### CITATION LIST

### PATENT LITERATURE

Patent Literature 1: JP2018-41821A
Patent Literature 2: JP2018-41822A
Patent Literature 3: JP2020-125436A

### SUMMARY OF INVENTION

### TECHNICAL PROBLEM

In the case of inspecting a large number of electronic components, the methods described in Patent Literatures 1 and 2 require a step of passing a current through each electronic component, a step of measuring a current value or a resistance value, and a step of determining whether the electronic component is good or bad, making it difficult to inspect efficiently. The method described in Patent Literature 3 can efficiently pass a current through a large number of electrically conductive pieces simultaneously and collectively, but there is no disclosure of a method for simultaneously and collectively performing a step of measuring the current value or the resistance value and a step of determining a defective product by comparing the current value or the resistance value with a threshold value, which does not provide a solution to the problem addressed by the present application.

An object of the present invention is to provide an electrical conductivity inspection method capable of efficiently inspecting an electrically conductive property of an inspection target. Another object of the present invention is to provide a separation method, in which, by using an electrically debondable pressure-sensitive adhesive layer, an electrically conductive property of an inspection target can be efficiently inspected and the inspection target remaining on the electrically debondable pressure-sensitive adhesive layer is easily separated. Still another object of the present invention is to provide an electrically debondable pressure-sensitive adhesive layer and a pressure-sensitive adhesive sheet suitable for use in the separation method.

### SOLUTION TO PROBLEM

As a result of intensive investigation, the inventors of the present invention have found that the above object can be achieved by an electrical conductivity inspection method including a specific process.

That is, the present invention provides an electrical conductivity inspection method including:
joining an inspection target and a fixing member together using an electrically debondable pressure-sensitive adhesive layer capable of joining the inspection target and the fixing member;
applying a voltage to the inspection target and the electrically debondable pressure-sensitive adhesive layer; and
determining an electrically conductive property of the inspection target according to a joining state between the inspection target and the fixing member after the voltage is applied.

In one aspect of the electrical conductivity inspection method according to the present invention, it may be determined whether the inspection target is an electrical conductor or an insulator based on the electrically conductive property of the inspection target.

In one aspect of the electrical conductivity inspection method according to the present invention, it may be determined whether the inspection target is a non-defective product or a defective product based on the electrically conductive property of the inspection target.

In one aspect of the electrical conductivity inspection method according to the present invention, the inspection target may be classified and separated at a same time as the electrically conductive property of the inspection target is determined.

In one aspect of the electrical conductivity inspection method according to the present invention, the fixing member may have electrical conductivity, and a voltage may be applied to the electrically debondable pressure-sensitive adhesive layer via the inspection target and the fixing member.

In one aspect of the electrical conductivity inspection method according to the present invention, the electrically debondable pressure-sensitive adhesive layer may have a single layer structure, the fixing member may have electrical conductivity, and a positive electrode for applying a voltage may be connected to the fixing member, and a negative electrode for applying a voltage may be connected to the inspection target.

In one aspect of the electrical conductivity inspection method according to the present invention, a voltage may be applied to the electrically debondable pressure-sensitive adhesive layer via the inspection target and an electrically conductive layer, in a state where a pressure-sensitive adhesive layer and an electrically conductive layer are further disposed between the electrically debondable pressure-sensitive adhesive layer and the fixing member.

In one aspect of the electrical conductivity inspection method according to the present invention, a positive electrode for applying a voltage may be connected to the electrically conductive layer, and a negative electrode for applying a voltage may be connected to the inspection target.

In one aspect of the electrical conductivity inspection method according to the present invention, the electrically debondable pressure-sensitive adhesive layer may contain an electrolyte.

In one aspect of the electrical conductivity inspection method according to the present invention, the electrically debondable pressure-sensitive adhesive layer may contain an ionic liquid.

In one aspect of the electrical conductivity inspection method according to the present invention, an anion in the ionic liquid may be at least one anion selected from the group consisting of (FSO₂)₂N⁻, (CF₃SO₂)₂N⁻, (CF₃CF₂SO₂)₂N⁻, (CF₃SO₂)₃C⁻, CH₃COO⁻, CF₃COO⁻, CF₃CF₂CF₂COO⁻, CF₃SO₃⁻, CF₃(CF₂)₃SO₃⁻, Br⁻, AlCl₄⁻, Al₂Cl₇⁻, NO₃⁻, BF₄⁻, PF₆⁻, AsF₆⁻, SbF₆⁻, and F(HF)ₙ⁻ (n represents an integer of 1 or more).

In addition, the inventors of the present invention have found that the above object can be achieved by a separation method including an additional process in the above electrical conductivity inspection method.

That is, the present invention provides a separation method in the above electrical conductivity inspection method, the separation method including:
after applying a voltage to the inspection target and the electrically debondable pressure-sensitive adhesive layer,
supplying a predetermined energy other than electricity or predetermined substance to the electrically debondable pressure-sensitive adhesive layer; and
determining an electrically conductive property of the inspection target, and separating a remaining inspection target joined to the electrically debondable pressure-sensitive adhesive layer after the voltage is applied.

In one aspect of the separation method according to the present invention, the remaining inspection target may be an insulator.

In one aspect of the separation method according to the present invention, heat may be supplied as the predetermined energy to the electrically debondable pressure-sensitive adhesive layer.

In one aspect of the separation method according to the present invention, an active energy ray may be supplied as the predetermined energy to the electrically debondable pressure-sensitive adhesive layer.

In one aspect of the separation method according to the present invention, after applying a voltage to the inspection target and the electrically debondable pressure-sensitive adhesive layer, the electrically conductive property of the inspection target may be determined, and then the predetermined energy other than electricity or a predetermined substance may be supplied to the electrically debondable pressure-sensitive adhesive layer to separate the remaining inspection target.

Further, the inventors of the present invention have found configurations of an electrically debondable pressure-sensitive adhesive layer and a pressure-sensitive adhesive sheet suitable for use in the above separation method.

The present invention provides an electrically debondable pressure-sensitive adhesive layer containing: a polymer; an electrolyte; and a thermally expandable filler.

The present invention provides an electrically debondable pressure-sensitive adhesive layer, which is cured by irradiation with an active energy ray or by heating, containing: a polymer; and an electrolyte.

The present invention provides an electrically debondable pressure-sensitive adhesive layer containing: a polymer; an electrolyte; and at least one compound selected from the group consisting of a surfactant and a compound having a polyoxyalkylene skeleton.

The present invention provides a pressure-sensitive adhesive sheet including any one of the above electrically debondable pressure-sensitive adhesive layers.

### ADVANTAGEOUS EFFECTS OF INVENTION

According to one aspect of the present invention, the electrically conductive property of the inspection target can be determined efficiently. According to another aspect of the present invention, the electrically conductive property of the inspection target can be determined efficiently, and the inspection target remaining on the electrically debondable pressure-sensitive adhesive layer can be easily separated. According to still another aspect of the present invention, it is possible to provide an electrically debondable pressure-sensitive adhesive layer and a pressure-sensitive adhesive sheet suitable for use in the above separation method.

### BRIEF DESCRIPTION OF DRAWINGS

[Fig. 1] Fig. 1 is a diagram schematically illustrating a process of an electrical conductivity inspection method according to a first embodiment of the present invention.
[Fig. 2] Fig. 2 is a schematic diagram illustrating an example of the electrical conductivity inspection method according to the first embodiment of the present invention.
[Fig. 3] Fig. 3 is a schematic diagram illustrating an example of a separation method according to the first embodiment of the present invention.
[Fig. 4] Fig. 4 is a diagram schematically illustrating a process of an electrical conductivity inspection method according to a second embodiment of the present invention.
[Fig. 5] Fig. 5 is a sectional view showing an outline of a method of a 180° peel test according to Examples.

### DESCRIPTION OF EMBODIMENTS

### (First Embodiment)

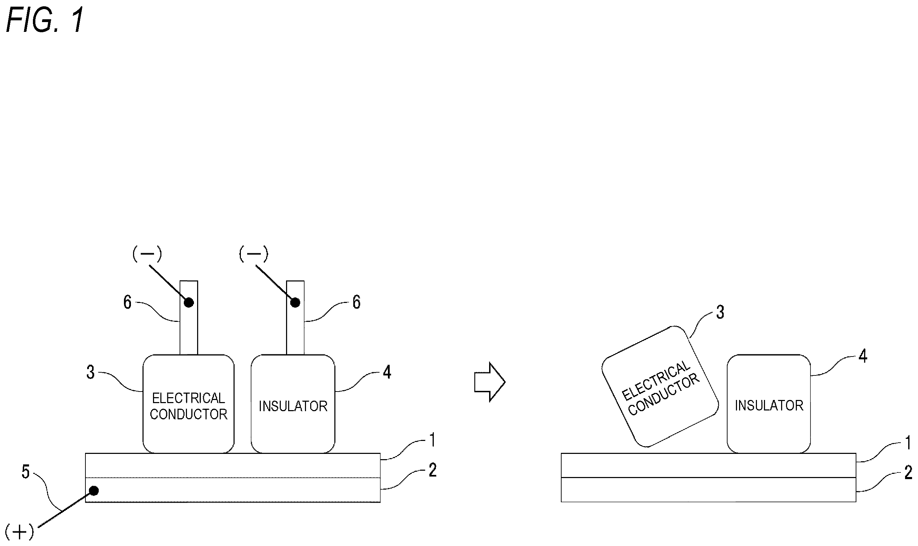

Specific embodiments related to the present invention will be described below with reference to the drawings. Fig. 1 is a diagram schematically illustrating a process of an electrical conductivity inspection method according to a first embodiment of the present invention.

### <Outline of Electrical Conductivity Inspection Method>

In the electrical conductivity inspection method according to the present embodiment, an electrical conductor 3 or an insulator 4 as an inspection target is joined to a fixing member 2 using an electrically debondable pressure-sensitive adhesive layer 1 capable of joining the inspection target and the fixing member 2, as shown on a left side in Fig. 1. Next, a voltage is applied to the inspection target and the electrically debondable pressure-sensitive adhesive layer 1 using a predetermined voltage application device, as shown in the left side in Fig. 1. In the present embodiment, a voltage is applied to the electrically debondable pressure-sensitive adhesive layer 1 via the inspection target and the fixing member. After the voltage is applied, whether the inspection target is good or bad is determined according to a joining state between the inspection target and the fixing member 2, as shown in a right side in Fig. 1. Hereinafter, each member used in the electrical conductivity inspection method will be described.

### <Electrically Debondable Pressure-sensitive Adhesive Layer>

The electrically debondable pressure-sensitive adhesive layer 1 is a pressure-sensitive adhesive layer made of an electrically debondable pressure-sensitive adhesive (electrically debondable type pressure-sensitive adhesive layer), and contains a polymer as a pressure-sensitive adhesive and an electrolyte. An adhesive force of the electrically debondable pressure-sensitive adhesive layer 1 to an adherend decreases when a voltage is applied.

Examples of the polymer to be contained in the electrically debondable pressure-sensitive adhesive layer 1 include an acrylic polymer, a rubber-based polymer, a vinyl alkyl ether-based polymer, a silicone-based polymer, a polyester-based polymer, a polyamide-based polymer, a urethane-based polymer, a fluorine-based polymer, and an epoxy-based polymer. The electrically debondable pressure-sensitive adhesive layer 1 may contain only one kind of polymer, or may contain two or more kinds of polymers.

From the viewpoint of cost reduction and realization of high productivity, it is preferable to contain an acrylic polymer. The acrylic polymer is a polymer containing monomer units derived from an alkyl acrylate and/or an alkyl methacrylate as main monomer units that are present in the largest amount by mass. Hereinafter, "(meth)acrylic" refers to "acrylic" and/or "methacrylic".

In the case where the electrically debondable pressure-sensitive adhesive layer 1 contains an acrylic polymer, the acrylic polymer preferably contains a monomer unit derived from an alkyl (meth)acrylate having an alkyl group having 1 to 14 carbon atoms. Examples of the alkyl (meth)acrylate include methyl (meth)acrylate, ethyl (meth)acrylate, propyl (meth)acrylate, isopropyl (meth)acrylate, n-butyl (meth)acrylate, sec-butyl (meth)acrylate, 1,3-dimethylbutyl acrylate, pentyl (meth)acrylate, isopentyl (meth)acrylate, hexyl (meth)acrylate, 2-ethylbutyl (meth)acrylate, heptyl (meth)acrylate, n-octyl (meth)acrylate, isooctyl (meth)acrylate, 2-ethylhexyl (meth)acrylate, n-nonyl (meth)acrylate, isononyl (meth)acrylate, n-decyl (meth)acrylate, isodecyl (meth)acrylate, n-dodecyl (meth)acrylate, n-tridecyl (meth)acrylate, and n-tetradecyl (meth)acrylate. Among these, preferred are n-butyl (meth)acrylate, sec-butyl (meth)acrylate, n-octyl (meth)acrylate, isooctyl (meth)acrylate, 2-ethylhexyl (meth)acrylate, n-nonyl (meth)acrylate, and isononyl (meth)acrylate. One kind of alkyl (meth)acrylate may be used, or two or more kinds of alkyl (meth)acrylates may be used.

A proportion of the monomer unit derived from the alkyl (meth)acrylate having an alkyl group having 1 to 14 carbon atoms in the acrylic polymer is preferably 50 mass% or more, more preferably 60 mass% or more, still more preferably 70 mass% or more, and even more preferably 80 mass% or more, from the viewpoint of realizing a high adhesive force for the electrically debondable pressure-sensitive adhesive layer 1. That is, a proportion of the alkyl (meth)acrylate having an alkyl group having 1 to 14 carbon atoms in a total amount of raw material monomers used to form the acrylic polymer is preferably 50 mass% or more, more preferably 60 mass% or more, still more preferably 70 mass% or more, and even more preferably 80 mass% or more, from the viewpoint of realizing a high adhesive force for the electrically debondable pressure-sensitive adhesive layer 1.

In the case where the electrically debondable pressure-sensitive adhesive layer 1 contains an acrylic polymer, the acrylic polymer preferably contains a monomer unit derived from a polar group-containing monomer from the viewpoint of realizing a high adhesive force for the electrically debondable pressure-sensitive adhesive layer 1. Examples of the polar group-containing monomer include a carboxy group-containing monomer, a methoxy group-containing monomer, a hydroxy group-containing monomer, and a vinyl group-containing monomer.

Examples of the carboxy group-containing monomer include acrylic acid, methacrylic acid, itaconic acid, maleic acid, fumaric acid, crotonic acid, isocrotonic acid, carboxyethyl (meth)acrylate, and carboxypentyl (meth)acrylate. Among these, acrylic acid and methacrylic acid are preferred. One kind of carboxy group-containing monomer may be used, or two or more kinds of carboxy group-containing monomers may be used.

Examples of the methoxy group-containing monomer include 2-methoxyethyl acrylate.

Examples of the hydroxy group-containing monomer include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethylcyclohexyl)methyl acrylate, N-methylol (meth)acrylamide, vinyl alcohol, allyl alcohol, 2-hydroxyethyl vinyl ether, 4-hydroxybutyl vinyl ether, and diethylene glycol monovinyl ether. Among these, 2-hydroxyethyl (meth)acrylate is preferred. One kind of hydroxy group-containing monomer may be used, or two or more kinds of hydroxy group-containing monomers may be used.

Examples of the vinyl group-containing monomer include vinyl acetate, vinyl propionate, and vinyl laurate. Among these, vinyl acetate is preferred. One kind of vinyl group-containing monomer may be used, or two or more kinds of vinyl group-containing monomers may be used.

A proportion of the monomer unit derived from the polar group-containing monomer in the acrylic polymer is preferably 0.1 mass% or more from the viewpoint of ensuring a cohesive force in the electrically debondable pressure-sensitive adhesive layer 1 and preventing adhesive residues on a surface of an adherend after the electrically debondable pressure-sensitive adhesive layer 1 is separated. That is, a proportion of the polar group-containing monomer in the total amount of the raw material monomers used to form the acrylic polymer is preferably 0.1 mass% or more from the viewpoint of ensuring the cohesive force and preventing adhesive residues. In addition, the proportion of the monomer unit derived from the polar group-containing monomer in the acrylic polymer is preferably 30 mass% or less from the viewpoint of appropriately expressing properties attributable to the monomer unit derived from the above alkyl (meth)acrylate having an alkyl group having 1 to 14 carbon atoms in the acrylic polymer. That is, the proportion of the polar group-containing monomer in the total amount of the raw material monomers used to form the acrylic polymer is preferably 30 mass% or less from the viewpoint of expressing the properties.

A method for obtaining the acrylic polymer by polymerizing the above monomers is not particularly limited, and any known method can be used. Examples of the polymerization method include solution polymerization, emulsion polymerization, bulk polymerization, and suspension polymerization.

A content of the polymer in the electrically debondable pressure-sensitive adhesive layer 1 is preferably 70 mass% or more, more preferably 80 mass% or more, still more preferably 85 mass% or more, and even more preferably 90 mass% or more, from the viewpoint of realizing a sufficient adhesive force in the electrically debondable pressure-sensitive adhesive layer 1.

The electrolyte to be contained in the electrically debondable pressure-sensitive adhesive layer 1 is a substance that can be ionized into anions and cations, and examples of such an electrolyte include an ionic liquid, an alkali metal salt, an alkaline earth metal salt, or an organic quaternary ammonium salt. The electrolyte to be contained in the electrically debondable pressure-sensitive adhesive layer 1 is preferably an ionic liquid, from the viewpoint of realizing good ability of electro-debonding in the electrically debondable pressure-sensitive adhesive layer 1. The ionic liquid is a liquid salt at room temperature (about 25°C) and contains an anion and a cation.

In the case where the electrically debondable pressure-sensitive adhesive layer 1 contains an ionic liquid, the anion in the ionic liquid preferably includes at least one selected from the group consisting of (FSO₂)₂N⁻, (CF₃SO₂)₂N⁻, (CF₃CF₂SO₂)₂N⁻, (CF₃SO₂)₃C⁻, CH₃COO⁻, CF₃COO⁻, CF₃CF₂CF₂COO⁻, CF₃SO₃⁻, CF₃(CF₂)₃SO₃⁻, Br⁻, AlCl₄⁻, Al₂Cl₇⁻, NO₃⁻, BF₄⁻, PF₆⁻, AsF₆⁻, SbF₆⁻, and F(HF)ₙ⁻ (n represents an integer of 1 or more).

Among these, the anion is preferably (FSO₂)₂N⁻ [bis(fluorosulfonyl)imide anion] and (CF₃SO₂)₂N⁻ [bis(trifluoromethanesulfonyl)imide anion] since these anions are chemically stable and suitable for realizing the ability of electro-debonding of the electrically debondable pressure-sensitive adhesive layer 1.

In the case where the electrically debondable pressure-sensitive adhesive layer 1 contains an ionic liquid, the cation in the ionic liquid preferably includes at least one selected from the group consisting of an imidazolium-based cation, a pyridinium-based cation, a pyrrolidinium-based cation, and an ammonium-based cation.

Examples of the imidazolium-based cation include a 1-methylimidazolium cation, a 1-ethyl-3-methylimidazolium cation, a 1-propyl-3-methylimidazolium cation, a 1-butyl-3-methylimidazolium cation, a 1-pentyl-3-methylimidazolium cation, a 1-hexyl-3-methylimidazolium cation, a 1-heptyl-3-methylimidazolium cation, a 1-octyl-3-methylimidazolium cation, a 1-nonyl-3-methylimidazolium cation, a 1-undecyl-3-methylimidazolium cation, a 1-dodecyl-3-methylimidazolium cation, a 1-tridecyl-3-methylimidazolium cation, a 1-tetradecyl-3-methylimidazolium cation, a 1-pentadecyl-3-methylimidazolium cation, a 1-hexadecyl-3-methylimidazolium cation, a 1-heptadecyl-3-methylimidazolium cation, a 1-octadecyl-3-methylimidazolium cation, a 1-undecyl-3-methylimidazolium cation, a 1-benzyl-3-methylimidazolium cation, a 1-butyl-2,3-dimethylimidazolium cation, and a 1,3-bis(dodecyl)imidazolium cation.

Examples of the pyridinium-based cation include a 1-butylpyridinium cation, a 1-hexylpyridinium cation, a 1-butyl-3-methylpyridinium cation, a 1-butyl-4-methylpyridinium cation, and a 1-octyl-4-methylpyridinium cation.

Examples of the pyrrolidinium-based cation include a 1-ethyl-1-methylpyrrolidinium cation and a 1-butyl-1-methylpyrrolidinium cation.

Examples of the ammonium-based cation include a tetraethylammonium cation, a tetrabutylammonium cation, a methyltrioctylammonium cation, a tetradecyltrihexylammonium cation, a glycidyltrimethylammonium cation, and a trimethylaminoethyl acrylate cation.

The ionic liquid in the electrically debondable pressure-sensitive adhesive layer 1 is particularly preferably an ionic liquid containing the above (FSO₂)₂N- [bis(fluorosulfonyl)imide anion] and a cation having a molecular weight of 160 or less, from the viewpoint of generating high ability of electro-debonding in the electrically debondable pressure-sensitive adhesive layer 1 by using high diffusivity of cations. Examples of the cation having a molecular weight of 160 or less include a 1-methylimidazolium cation, a 1-ethyl-3-methylimidazolium cation, a 1-propyl-3-methylimidazolium cation, a 1-butyl-3-methylimidazolium cation, a 1-pentyl-3-methylimidazolium cation, a 1-butylpyridinium cation, a 1-hexylpyridinium cation, a 1-butyl-3-methylpyridinium cation, a 1-butyl-4-methylpyridinium cation, a 1-ethyl-1-methylpyrrolidinium cation, a 1-butyl-1-methylpyrrolidinium cation, a tetraethylammonium cation, a glycidyltrimethylammonium cation, and a trimethylaminoethyl acrylate cation.

Examples of commercially available products of the ionic liquid to be contained in the electrically debondable pressure-sensitive adhesive layer 1 include "ELEXCEL AS-110", "ELEXCEL MP-442", "ELEXCEL IL-210", "ELEXCEL MP-471", "ELEXCEL MP-456", and "ELEXCEL AS-804" manufactured by DKS Co. Ltd.

In the case where the electrically debondable pressure-sensitive adhesive layer 1 contains an alkali metal salt, examples of the alkali metal salt include LiCl, Li₂SO₄, LiBF₄, LiPF₆, LiClO₄, LiAsF₆, LiCF₃SO₃, LiN(SO₂CF₃)₂, LiN(SO₂C₂F₅)₂, LiC(SO₂CF₃)₃, NaCl, Na₂SO₄, NaBF₄, NaPF₆, NaClO₄, NaAsF₆, NaCF₃SO₃, NaN(SO₂CF₃)₂, NaN(SO₂C₂F₅)₂, NaC(SO₂CF₃)₃, KCl, K₂SO₄, KBF₄, KPF₆, KClO₄, KAsF₆, KCF₃SO₃, KN(SO₂CF₃)₂, KN(SO₂C₂F₅)₂, and KC(SO₂CF₃)₃.

The ionic liquid preferably has an ionic conductivity of 0.1 mS/cm or more. The ionic conductivity of the ionic liquid is more preferably 1 mS/cm or more, still more preferably 3 mS/cm or more, even more preferably 5 mS/cm or more, even still more preferably 10 mS/cm or more, particularly preferably 15 mS/cm or more, and most preferably 20 mS/cm or more. There is no particular upper limit, but by having the above ionic conductivity, the adhesive force sufficiently decreases even at a low voltage. Note that, the ionic conductivity can be measured by using an AC impedance method using, for example, a 1260 frequency response analyzer manufactured by Solartron.

A content of the ionic liquid in the electrically debondable pressure-sensitive adhesive layer 1 is, for example, 0.1 parts by mass or more with respect to 100 parts by mass of the polymer in the electrically debondable pressure-sensitive adhesive layer 1 in order to impart ability of electro-debonding to the electrically debondable pressure-sensitive adhesive layer 1, and is preferably 0.5 parts by mass or more, more preferably 0.6 parts by mass or more, still more preferably 0.8 parts by mass or more, particularly preferably 1.0 parts by mass or more, and most preferably 1.5 parts by mass or more, from the viewpoint of generating better ability of electro-debonding. The content of the ionic liquid in the electrically debondable pressure-sensitive adhesive layer 1 is preferably 30 parts by mass or less, more preferably 20 parts by mass or less, still more preferably 15 parts by mass or less, particularly preferably 10 parts by mass or less, and most preferably 5 parts by mass or less with respect to 100 parts by mass of the polymer in the electrically debondable pressure-sensitive adhesive layer 1, from the viewpoint of realizing a good balance between a good adhesive force and ability of electro-debonding for the electrically debondable pressure-sensitive adhesive layer 1.

The electrically debondable pressure-sensitive adhesive layer 1 may contain polyethylene glycol, polypropylene glycol, or tetraethylene glycol dimethyl ether, if necessary, for the purpose of assisting movement of the ionic liquid when a voltage is applied. As polyethylene glycol, polypropylene glycol, or tetraethylene glycol dimethyl ether, those having a number average molecular weight of 100 to 6,000 can be used. In the case where these components are contained, a content thereof is preferably 0.1 parts by mass or more, more preferably 0.5 parts by mass or more, still more preferably 1 part by mass or more, and is preferably 30 parts by mass or less, more preferably 20 parts by mass or less, still more preferably 15 parts by mass or less, with respect to 100 parts by mass of the polymer.

The electrically debondable pressure-sensitive adhesive layer 1 may contain other components within the range that does not impair the effects of the present invention. Examples of such components include a tackifier, a silane coupling agent, a colorant, a pigment, a dye, a surface lubricant, a leveling agent, a softener, an antioxidant, an ageing inhibitor, a light stabilizer, a polymerization inhibitor, an inorganic or organic filler, a metal powder, a particulate matter, a corrosion inhibitor, and a foil. Various additives can be used in a resin composition. A content of these components is determined depending on the purpose of use within a range that does not impair the effects of the present invention. For example, it is 10 parts by mass or less with respect to 100 parts by mass of the polymer, for example.

A thickness of the electrically debondable pressure-sensitive adhesive layer 1 is not particularly limited, and is preferably 1 µm or more, more preferably 3 µm or more, still more preferably 5 µm or more, and particularly preferably 10 µm or more, from the viewpoint of realizing a good adhesion property in the electrically debondable pressure-sensitive adhesive layer 1. In addition, the thickness is preferably 1,000 µm or less, more preferably 500 µm or less, still more preferably 100 µm or less, and particularly preferably 50 µm or less, from the viewpoint of reducing the voltage applied when separating the electrically debondable pressure-sensitive adhesive layer 1 from an adherend.

Examples of an electrically debondable pressure-sensitive adhesive layer suitable for use in a separation method and the like to be described later, and a pressure-sensitive adhesive sheet including the electrically debondable pressure-sensitive adhesive layer include aspects 1 to 3 to be described later. Note that, the following description, the pressure-sensitive adhesive sheet including the electrically debondable pressure-sensitive adhesive layer may be simply referred to as a pressure-sensitive adhesive sheet.

The pressure-sensitive adhesive sheet according to the present embodiment is not particularly limited as long as it has at least one electrically debondable pressure-sensitive adhesive layer described above. The pressure-sensitive adhesive sheet according to the present embodiment may include a pressure-sensitive adhesive layer containing no electrolyte (hereinafter, may be referred to as "another pressure-sensitive adhesive layer") other than the electrically debondable pressure-sensitive adhesive layer. The pressure-sensitive adhesive sheet according to the present embodiment may include a substrate, an electrically conductive layer, a conduction substrate, an intermediate layer, an undercoat layer, and the like in addition to the above. The pressure-sensitive adhesive sheet according to the present embodiment may have, for example, a form in which the pressure-sensitive adhesive sheet is wound in a roll shape or a sheet-like form. Note that, the "pressure-sensitive adhesive sheet" also includes meaning of a "pressure-sensitive adhesive tape". That is, the pressure-sensitive adhesive sheet according to the present embodiment may be a pressure-sensitive adhesive tape having a tape-like form.

The pressure-sensitive adhesive sheet according to the present embodiment may be a double-sided pressure-sensitive adhesive sheet including no substrate and only including an electrically debondable pressure-sensitive adhesive layer, that is, including no substrate layer (substrate-free). The pressure-sensitive adhesive sheet according to the present embodiment may be a double-sided pressure-sensitive adhesive sheet including a substrate, in which both surfaces of the substrate are pressure-sensitive adhesive layers (an electrically debondable pressure-sensitive adhesive layer or another pressure-sensitive adhesive layer). In addition, the pressure-sensitive adhesive sheet according to the present embodiment may be a single-sided pressure-sensitive adhesive sheet including a substrate and an electrically debondable pressure-sensitive adhesive layer laminated on one surface of the substrate. Note that, the pressure-sensitive adhesive sheet according to the present embodiment may include a separator (release liner) for the purpose of protecting the surface of the pressure-sensitive adhesive layer, but the separator is not included in the pressure-sensitive adhesive sheet according to the present embodiment.

The substrate is not particularly limited, and examples thereof include a paper base substrate such as paper, a fiber base substrate such as cloth and nonwoven fabric, a plastic substrate such as a film or a sheet made of various plastics (a polyolefin-based resin such as polyethylene and polypropylene, a polyester-based resin such as polyethylene terephthalate, an acrylic resin such as polymethyl methacrylate, and the like), and a laminate thereof. The substrate may have a form of a single layer and may also have a form of multi-layers. Note that, the substrate may be subjected to, if necessary, various treatments such as a back-face treatment, an antistatic treatment, and an undercoating treatment.

The electrically conductive layer is not particularly limited as long as it is a layer having electrical conductivity, and may be a metal-based substrate such as a metal (for example, aluminum, magnesium, copper, iron, tin, or gold) foil or a metal plate (for example, aluminum, magnesium, copper, iron, tin, or silver). Further, the electrically conductive layer may be an electrically conductive polymer or the like, or may be a metal vapor deposition film provided on the substrate.

The conduction substrate is not particularly limited as long as it is a substrate including an electrically conductive layer (passing a current), and examples thereof include a substrate including an electrically conductive layer such as a metal layer laminated on a surface thereof. For example, there is a substrate in which a metal layer is formed on a surface of the substrate exemplified above by a method such as a plating method, a chemical vapor deposition method, and sputtering. Examples of the metal layer include the metal, the metal plate, and the electrically conductive polymer exemplified above.

A thickness of the electrically debondable pressure-sensitive adhesive layer is preferably 1 µm or more and 1000 µm or less in terms of adhesiveness when no voltage is applied. An upper limit of the thickness is more preferably 500 µm, still more preferably 100 µm, and particularly preferably 30 µm, and a lower limit thereof is more preferably 3 µm, still more preferably 5 µm, and particularly preferably 8 µm. Note that, in the case where the pressure-sensitive adhesive sheet is a substrate-free double-sided pressure-sensitive adhesive sheet only including one electrically debondable pressure-sensitive adhesive layer, the thickness of the electrically debondable type pressure-sensitive adhesive layer is a thickness of the pressure-sensitive adhesive sheet.

Components contained in the another pressure-sensitive adhesive layer and contents thereof may be the same as those described above for the components contained in the electrically debondable pressure-sensitive adhesive layer and the contents thereof, except for the electrolyte.

A thickness of the another pressure-sensitive adhesive layer is preferably 1 µm or more and 2,000 µm or less in terms of the adhesion property. An upper limit of the thickness is more preferably 1,000 µm, still more preferably 500 µm, and particularly preferably 100 µm, and a lower limit thereof is more preferably 3 µm, still more preferably 5 µm, and particularly preferably 8 µm.

A thickness of the substrate is preferably 10 µm or more and 1,000 µm or less. An upper limit of the thickness is more preferably 500 µm, still more preferably 300 µm, and particularly preferably 100 µm, and a lower limit thereof is more preferably 12 µm, and still more preferably 25 µm.

A thickness of the electrically conductive layer is preferably 0.001 µm or more and 1,000 µm or less. An upper limit of the thickness is more preferably 500 µm, still more preferably 300 µm, even more preferably 50 µm, and even still more preferably 10 µm, and a lower limit of the thickness is more preferably 0.01 µm, still more preferably 0.03 µm, and even more preferably 0.05 µm.

A thickness of the conduction substrate is preferably 10 µm or more and 1,000 µm or less. An upper limit of the thickness is more preferably 500 µm, still more preferably 300 µm, and particularly preferably 100 µm, and a lower limit thereof is more preferably 12 µm, and still more preferably 25 µm.

Surfaces of the electrically debondable type pressure-sensitive adhesive layer and the another pressure-sensitive adhesive layer in the pressure-sensitive adhesive sheet according to the present embodiment may be protected by a separator (release liner). The separator is not particularly limited, and examples thereof include a release liner formed by silicone-treating a surface of a substrate (liner substrate) of paper, a plastic film, and the like, and a release liner formed by laminating a polyolefin-based resin on a surface of a substrate (liner substrate) of paper, a plastic film, and the like. A thickness of the separator is not particularly limited, and is preferably 10 µm or more and 100 µm or less.

The first aspect relates to an electrically debondable pressure-sensitive adhesive layer containing a polymer, an electrolyte, and a thermally expandable filler, and a pressure-sensitive adhesive sheet including the electrically debondable pressure-sensitive adhesive layer.

Here, various suitable examples of the polymer, the electrolyte, and other optional components in the electrically debondable pressure-sensitive adhesive layer and the pressure-sensitive adhesive sheet according to the first aspect are as described above.

The electrically debondable pressure-sensitive adhesive layer and the pressure-sensitive adhesive sheet according to the first aspect contains a thermally expandable filler. The thermally expandable filler is a filler that can expand or foam when heated. The electrically debondable pressure-sensitive adhesive layer and the pressure-sensitive adhesive sheet containing the thermally expandable filler are uneven on a pressure-sensitive adhesive surface by heating, therefore an adhesion force is decreased. That why, the adhesion force is sufficient when the adhesion force is required and the detachability is excellent when debonding is required.

In addition, the electrically debondable pressure-sensitive adhesive layer and the pressure-sensitive adhesive sheet according to the first aspect contain an electrolyte such as an ionic liquid, and therefore also have ability of electro-debonding.

A content proportion of the thermally expandable filler can be appropriately set according to a desired decrease in adhesion force and the like. The content proportion of the thermally expandable filler is preferably 5 parts by mass to 50 parts by mass, more preferably 10 parts by mass to 45 parts by mass, still more preferably 15 parts by mass to 40 parts by mass, and particularly preferably 20 parts by mass to 30 parts by mass, with respect to 100 parts by mass of the polymer in the adhesive. Within such a range, the ability of electro-debonding of the pressure-sensitive adhesive layer can be maintained, a smooth pressure-sensitive adhesive layer can be formed before the thermally expandable filler is foamed, and a pressure-sensitive adhesive layer having a good uneven surface can be formed after the thermally expandable filler is foamed.

The content proportion of the thermally expandable filler is preferably 5 parts by mass to 60 parts by mass, more preferably 10 parts by mass to 55 parts by mass, still more preferably 20 parts by mass to 45 parts by mass, and particularly preferably 30 parts by mass to 40 parts by mass with respect to 100 parts by mass of the polymer in the adhesive, from the viewpoint of forming a pressure-sensitive adhesive layer having a good uneven surface after the thermally expandable filler is foamed.

As the thermally expandable filler, any appropriate thermally expandable filler can be used. As the thermally expandable filler, for example, microspheres having a substance that expands easily when heated encapsulated in an elastic shell can be used. Such a thermally expandable filler can be produced by using any appropriate method, for example, a coacervation method or an interfacial polymerization method.

Examples of the substance that expands easily when heated include: low boiling point liquids such as propane, propylene, butene, normal butane, isobutane, isopentane, neopentane, normal pentane, normal hexane, isohexane, heptane, octane, petroleum ether, methane halides, and tetraalkylsilanes; and azodicarbonamide gasified by pyrolysis.

Examples of a substance constituting the shell include polymers formed of: nitrile monomers such as acrylonitrile, methacrylonitrile, α-chloroacrylonitrile, α-ethoxyacrylonitrile, and fumaronitrile; carboxylic acid monomers such as acrylic acid, methacrylic acid, itaconic acid, maleic acid, fumaric acid, and citraconic acid; vinylidene chloride; vinyl acetate; (meth)acrylates such as methyl (meth)acrylate, ethyl (meth)acrylate, n-butyl (meth)acrylate, isobutyl (meth)acrylate, t-butyl (meth)acrylate, isobornyl (meth)acrylate, cyclohexyl (meth)acrylate, benzyl (meth)acrylate, and β-carboxyethyl acrylate; styrene monomers such as styrene, α-methylstyrene, and chlorostyrene; and amide monomers such as acrylamide, substituted acrylamide, methacrylamide, and substituted methacrylamide. The polymer formed of these monomers may be a homopolymer or a copolymer. Examples of the copolymer include a vinylidene chloride-methyl methacrylate-acrylonitrile copolymer, a methyl methacrylate-acrylonitrile-methacrylonitrile copolymer, a methyl methacrylate-acrylonitrile copolymer, and an acrylonitrile-methacrylonitrile-itaconic acid copolymer.

As the thermally expandable filler, an inorganic foaming agent or an organic foaming agent may be used. Examples of the inorganic foaming agent include ammonium carbonate, ammonium hydrogen carbonate, sodium hydrogen carbonate, ammonium nitrite, sodium borohydride, and various azides. Examples of the organic foaming agent include: fluorinated alkane salts such as trichloromonofluoromethane and dichloromonofluoromethane; azo compounds such as azobisisobutyronitrile, azodicarbonamide, and barium azodicarboxylate; hydrazine compounds such as paratoluenesulfonylhydrazide, diphenylsulfone-3,3'-disulfonylhydrazide, 4,4'-oxybis(benzenesulfonylhydrazide), and allylbis(sulfonylhydrazide); semicarbazide compounds such as p-toluylenesulfonylsemicarbazide and 4,4'-oxybis(benzenesulfonylsemicarbazide); triazole compounds such as 5-morpholyl-1,2,3,4-thiatriazole; and N-nitroso compounds such as N,N'-dinitrosopentamethylenetetramine and N,N'-dimethyl-N,N'-dinitrosoterephthalamide.

A commercially available product of the thermally expandable filler may be used. Specific examples of the commercially available product of the thermally expandable filler include: product name "Matsumoto Microsphere" (grade: F-30, F-30D, F-36D, F-36LV, F-50, F-50D, F-65, F-65D, FN-100SD, FN-100SS, FN-100SSD, FN-180SS, FN-180SSD, F-190D, F-260D, and F-2800D) manufactured by Matsumoto Yushi-Seiyaku Co., Ltd; product name "Expancel" (grade: 053-40, 031-40, 920-40, 909-80, and 930-120) manufactured by Japan Fillite co., ltd.; "DAIFORM" (grade: H750, H850, H1100, S2320D, S2640D, M330, M430, and M520) manufactured by KUREHA CORPORATION; and "ADVANCELL" (grade: EML101, EMH204, EHM301, EHM302, EHM303, EM304, EHM401, EM403, and EM501) manufactured by SEKISUI CHEMICAL CO., LTD.

A volume cumulative particle diameter D50 (particle diameter at 50% cumulative volume) of the thermally expandable filler is preferably 5 µm to 50 µm, more preferably 8 µm to 40 µm, still more preferably 10 µm to 30 µm, and particularly preferably 15 µm to 25 µm. Within such a range, it is possible to obtain a pressure-sensitive adhesive sheet which can maintain the ability of electro-debonding of the pressure-sensitive adhesive layer and in which an adhesive expansion property is preferably adjusted to prevent tilting of an adherend during debonding.

The volume cumulative particle diameter D50 (particle diameter at 50% cumulative volume) of the thermally expandable filler is preferably 5 µm to 60 µm, more preferably 10 µm to 50 µm, still more preferably 20 µm to 45 µm, and particularly preferably 30 µm to 40 µm, from the viewpoint of forming a pressure-sensitive adhesive layer having a good uneven surface after the thermally expandable filler is foamed.

In the case of using an electrically debondable pressure-sensitive adhesive layer containing the thermally expandable filler, conditions in a heat treatment can be selected such that a adhesion force reducing effect of the heat treatment is appropriately exhibited. A temperature in the heat treatment is, for example, 70°C to 270°C, and preferably 110°C to 150°C. A time for the heat treatment is, for example, 30 seconds to 10 minutes, and preferably 1 minute to 5 minutes.

The second aspect relates to an electrically debondable pressure-sensitive adhesive layer, which is cured by irradiation with an active energy ray or by heating, containing a polymer and an electrolyte, and a pressure-sensitive adhesive sheet including the electrically debondable pressure-sensitive adhesive layer.

Here, in the following description, the pressure-sensitive adhesive layer, which is cured by irradiation with an active energy ray is referred to as an "active energy ray-curable pressure-sensitive adhesive layer". Note that, in the present description, the "active energy rays" is a concept that encompasses light such as ultraviolet light, visible light, and infrared light, and radiation such as α rays, β rays, γ rays, electron beams, neutron beams, and X-rays.

In the following description, the pressure-sensitive adhesive layer, which is cured by heating is referred to as a "thermosetting pressure-sensitive adhesive layer".

That is, the electrically debondable pressure-sensitive adhesive layer according to the second aspect has the ability of electro-debonding of an electrically debondable pressure-sensitive adhesive layer, and also has the property of being cured by irradiation with an active energy ray or by heating of the "active energy ray-curable pressure-sensitive adhesive layer" or the "thermosetting pressure-sensitive adhesive layer".

### (Active Energy Ray-curable Pressure-sensitive Adhesive Layer)

A suitable example of the active energy ray-curable pressure-sensitive adhesive layer is one that exhibits curability by containing a carbon-carbon double bond within the pressure-sensitive adhesive layer. The carbon-carbon double bond is chemically stable and does not react with moisture, acidity, and the like in the air in general industrially applicable storage environments. On the other hand, when radicals are generated by irradiation with an active energy ray, a reaction (for example, a polymerization reaction or a crosslinking reaction) occurs and the material is cured. From the viewpoint of ease of handling and the like, a preferred example of the active energy ray is light (for example, ultraviolet light).

In a pressure-sensitive adhesive layer that exhibits curability by containing a carbon-carbon double bond, a form of the carbon-carbon double bond in the pressure-sensitive adhesive layer is not particularly limited. The carbon-carbon double bond may be contained in the pressure-sensitive adhesive layer in the form of, for example, a polymer having a carbon-carbon double bond (for example, a base polymer) or a monomer having a carbon-carbon double bond (for example, an unreacted polyfunctional monomer as described above). These may be used alone or in combination of two or more kinds thereof.

The form of the carbon-carbon double bond contained in the polymer and the form of the carbon-carbon double bond contained in the monomer are not particularly limited. For example, the carbon-carbon double bond may be present in the polymer or the monomer in the form of an ethylenically unsaturated group. Examples of the ethylenically unsaturated group include a (meth)acryloyl group, a vinyl group, an allyl group, and a methallyl group. A (meth)acryloyl group is preferred from the viewpoint of reactivity.

### (Polymer Having Carbon-carbon Double Bond)

In some aspects, the active energy ray-curable pressure-sensitive adhesive layer preferably contains a polymer having a carbon-carbon double bond. Hereinafter, the polymer having a carbon-carbon double bond is also referred to as a "polymer (PD)". For example, a polymer (PD) having a carbon-carbon double bond in the form of an ethylenically unsaturated group is preferred. In some preferred aspects, the polymer (PD) may be contained in the active energy ray-curable pressure-sensitive adhesive layer as a base polymer of the pressure-sensitive adhesive layer. In some other aspects, the polymer (PD) may be contained in the active energy ray-curable pressure-sensitive adhesive layer as a minor component used in addition to a base polymer not having a carbon-carbon double bond. The active energy ray-curable pressure-sensitive adhesive layer may contain the polymer (PD) as a base polymer and further contain a monomer having a carbon-carbon double bond (for example, an unreacted polyfunctional monomer) as a minor component.

The form of the carbon-carbon double bond in the polymer (PD) is not particularly limited. The polymer (PD) may be a polymer having a carbon-carbon double bond in a side chain, or may be a polymer having a carbon-carbon double bond in a main chain. Here, "having a carbon-carbon double bond in the main chain" encompasses the presence of a carbon-carbon double bond in a main chain skeleton of the polymer (PD) and the presence of a carbon-carbon double bond at the end of the main chain. From the viewpoint of the reactivity of the carbon-carbon double bond, a polymer (PD) having a carbon-carbon double bond in the side chain can be preferably used. A method for incorporating a carbon-carbon double bond into the polymer (PD) is not particularly limited, and an appropriate method can be selected from methods known to those skilled in the art.

The polymer (PD) is not particularly limited, and an appropriate polymer can be selected and used in consideration of the properties and the like of the pressure-sensitive adhesive layer. The polymer (PD) is preferably a polymer (secondary polymer) obtained by introducing a carbon-carbon double bond, by using a method such as chemical modification, into a polymer (primary polymer) that does not have a carbon-carbon double bond or that has a lower content of carbon-carbon double bond than that of the target polymer.

Specific examples of a method for introducing the carbon-carbon double bond into the primary polymer include a method of preparing a primary polymer by copolymerizing a monomer having a functional group (functional group A), and reacting the primary polymer with a compound having a functional group (functional group B) capable of reacting with the functional group A and having a carbon-carbon double bond in one molecule (hereinafter also referred to as a "functional group B-containing unsaturated compound") in a manner that the carbon-carbon double bond is not lost. The reaction between the functional group A and the functional group B is preferably a reaction not involving the generation of radicals, such as a condensation reaction or an addition reaction.

Examples of a combination of functional group A and the functional group B include a combination of a carboxy group and an epoxy group, a combination of a carboxy group and an aziridyl group, and a combination of a hydroxy group and an isocyanate group. Among these, a combination of a hydroxy group and an isocyanate group is preferred from the viewpoint of reaction traceability. In addition, as for the combination of the functional groups A and B, as long as a polymer having a carbon-carbon double bond is obtained, one of the functional groups in the combination may be the functional group A and the other may be the functional group B, or one of the functional groups may be the functional group B and the other may be the functional group A. For example, in the case of a combination of a hydroxy group and an isocyanate group, the functional group A may be a hydroxy group (in which case the functional group B is an isocyanate group) or may be an isocyanate group (in which case the functional group B is a hydroxy group). Among these, preferred is a combination in which the primary polymer has a hydroxy group and the above compound has an isocyanate group. This combination is particularly preferred in the case where the primary polymer is an acrylic polymer.

In addition, a suitable example of a method for obtaining the polymer having a carbon-carbon double bond is a method of using a vinyl alcohol-based polymer (typically, polyvinyl alcohol) as the primary polymer and reacting the vinyl alcohol-based polymer (typically, a vinyl alcohol-based polymer not having a carbon-carbon double bond) with a vinyl halide such as vinyl bromide or an allyl halide such as allyl bromide. In this method, the reaction is carried out under appropriate basic conditions, and a vinyl alcohol-based polymer having a vinyl group in the side chain is obtained by this reaction. In addition, for example, a method of preparing the polymer having a carbon-carbon double bond using a microorganism that produces a polymer, as disclosed in JP4502363B, may be used. In this method, various conditions such as a microorganism species and microorganism culture conditions may be set by using the conditions described in the above patent literature or by appropriately modifying the conditions within the scope of the technical common sense of those skilled in the art.

A molar ratio (M_{A}/M_{B}) of moles (M_{A}) of the functional group A to moles (M_{B}) of the functional group B is generally appropriately 0.2 or more from the viewpoint of the reactivity therebetween, and may be 0.5 or more, 0.7 or more, or 1.0 or more. In some aspects, the molar ratio (M_{A}/M_{B}) may be more than 1.0, more than 1.5, or more than 2.0. For example, in the case where the functional group A is used in another reaction (such as a crosslinking reaction with a crosslinking agent), the molar ratio (M_{A}/M_{B}) is preferably more than 1.0. In addition, the molar ratio (M_{A}/M_{B}) may be, for example, 20 or less. In some aspects, the molar ratio (M_{A}/M_{B}) is preferably 10 or less, and may be 5.0 or less, 2.5 or less, 1.8 or less, 1.5 or less, or 1.3 or less, from the viewpoint of achieving a good balance between adhesiveness to an adherend before light irradiation and peelability from the adherend after light irradiation (for example, peelability by water peeling).

A usage amount of the compound having the functional group B and the carbon-carbon double bond (hereinafter also referred to as the "functional group B-containing unsaturated compound") can be, for example, 1.0 part by weight or more, and may be 3.0 parts by weight or more, 5.0 parts by weight or more, or 7.0 parts by weight or more, with respect to 100 parts by weight of the primary polymer having the functional group A, in a range where the above molar ratio (M_{A}/M_{B}) is satisfied. In some aspects, the usage amount of the functional group B-containing unsaturated compound is preferably 9.0 parts by weight or more, more preferably 10 parts by weight or more, and may be 12 parts by weight or more, 14 parts by weight or more, or 16 parts by weight or more, with respect to 100 parts by weight of the primary polymer, from the viewpoint of achieving a higher level of both the adhesiveness before light irradiation and the peelability after light irradiation (for example, peelability by water peeling). In addition, the usage amount of the functional group B-containing unsaturated compound can be, for example, less than 40 parts by weight, and is generally appropriately less than 35 parts by weight, preferably less than 30 parts by weight, and may be less than 25 parts by weight, or less than 20 parts by weight, with respect to 100 parts by weight of the primary polymer. In some aspects, the usage amount of the functional group B-containing unsaturated compound may be less than 18 parts by weight, may be less than 16 parts by weight, less than 13 parts by weight, less than 10 parts by weight, or less than 7 parts by weight, with respect to 100 parts by weight of the primary polymer.

A suitable example of the polymer having a carbon-carbon double bond is, for example, an acrylic polymer having a (meth)acryloyl group introduced into the side chain. Such an acrylic polymer can be obtained, for example, by reacting an acrylic primary polymer into which a hydroxy group (functional group A) has been introduced by copolymerization with a compound having a carbon-carbon double bond and an isocyanate group (functional group B) in a manner that the carbon-carbon double bond is not lost.

In addition, the polymer having a carbon-carbon double bond may be, for example, a diene-based polymer (typically, a conjugated diene-based polymer). The diene-based polymer (typically, a conjugated diene-based polymer) is typically a polymer obtained by polymerizing or copolymerizing a diene (typically, a conjugated diene). Examples of the diene-based polymer (typically, a conjugated diene-based polymer) include: butadiene-based polymers such as polybutadiene and a styrene-butadiene copolymer; isoprene-based polymers such as polyisoprene and a styreneisoprene copolymer; and chloroprene-based polymers such as polychloroprene.

Other examples of the active energy ray-curable pressure-sensitive adhesive layer include a pressure-sensitive adhesive layer containing a polymer having a structure other than a carbon-carbon double bond, the structure inducing a crosslinking reaction by irradiation with an active energy ray. For example, an adhesive containing a polymer having a benzophenone structure in the side chain can express active energy ray curability by photocrosslinking using the benzophenone structure. As the polymer having a benzophenone structure in the side chain, an acrylic polymer having a benzophenone structure in the side chain can be preferably used.

### (Photoinitiator)

In the case of using ultraviolet light as the active energy ray for curing the active energy ray-curable pressure-sensitive adhesive layer, the pressure-sensitive adhesive layer preferably contains a photoinitiator from the viewpoint of promoting the reaction or improving the efficiency of using light energy.

Examples of the photoinitiator include a benzoin ether-based photoinitiator, an acetophenone-based photoinitiator, an α-hydroxyketone-based photoinitiator, an aromatic sulfonyl chloride-based photoinitiator, a photoactive oxime-based photoinitiator, a benzoin-based photoinitiator, a benzyl-based photoinitiator, a benzophenone-based photoinitiator, a ketal-based photoinitiator, a thioxanthone-based photoinitiator, an α-aminoketone-based photoinitiator, and an acylphosphine oxide-based photoinitiator. The photoinitiator may be used alone or in combination of two or more kinds thereof.

Examples of the benzoin ether-based photoinitiator include benzoin methyl ether, benzoin ethyl ether, benzoin propyl ether, benzoin isopropyl ether, benzoin isobutyl ether, 2,2-dimethoxy-1,2-diphenylethan-1-one, and anisole methyl ether. Examples of the acetophenone-based photoinitiator include 2,2-diethoxyacetophenone, 2,2-dimethoxy-2-phenylacetophenone, 1-hydroxy-cyclohexyl-phenyl ketone, 4-phenoxydichloroacetophenone, and 4-t-butyl-dichloroacetophenone. Examples of the α-hydroxyketone-based photoinitiator include 2-hydroxy-2-methyl-1-phenyl-propan-1-one and 1-[4-(2-hydroxyethoxy)-phenyl]-2-hydroxy-2-methyl-1-propan-1-one. Examples of the aromatic sulfonyl chloride-based photoinitiator include 2-naphthalenesulfonyl chloride. Examples of the photoactive oxime-based photoinitiator include 1-phenyl-1,1-propanedione-2-(o-ethoxycarbonyl)-oxime. Examples of the benzoin-based photoinitiator include benzoin. Examples of the benzyl-based photoinitiator include benzyl. Examples of the benzophenone-based photoinitiator include benzophenone, benzoylbenzoic acid, 3,3'-dimethyl-4-methoxybenzophenone, polyvinylbenzophenone, and α-hydroxycyclohexyl phenyl ketone. Examples of the ketal-based photoinitiator include benzyl dimethyl ketal. Examples of the thioxanthone-based photoinitiator include thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, 2,4-diisopropylthioxanthone, and dodecylthioxanthone. Examples of the α-aminoketone-based photoinitiator include 2-methyl-1-[4-(methylthio)phenyl]-2-morpholinopropan-1-one and 2-benzyl-2-dimethylamino-1-(4-morpholinophenyl)-butanone-1. Examples of the acylphosphine oxide-based photoinitiator include 2,4,6-trimethylbenzoyldiphenylphosphine oxide and bis(2,4,6-trimethylbenzoyl)-phenylphosphine oxide.

A commercially available product of the photoinitiator may be used. Examples thereof include product names "Omnirad 651", "Omnirad 184", "Omnirad 2959", "Omnirad 907", "Omnirad 369", "Omnirad 1173", and "Omnirad TPO", manufactured by IGM Regins.

In some aspects, as the photoinitiator, a photoinitiator that is unlikely to decompose or generate radicals when heated can be preferably used. For example, as the photoinitiator, a heat-resistant photoinitiator having a 10 wt% reduction temperature of 200°C or higher can be used. By using such a heat-resistant photoinitiator, even when the pressure-sensitive adhesive layer is exposed to a high temperature before the curing treatment, the adhesion force reducing effect due to the curing treatment using active energy rays is unlikely to be impaired. Note that, the 10 wt% reduction temperature means an environmental temperature at which, when the photoinitiator is placed under a nitrogen atmosphere and the environmental temperature is increased from 23°C to 300°C at a temperature increase rate of 2°C/min, the weight of the photoinitiator is reduced by 10 wt% of the weight before the temperature increase (that is, the weight of the photoinitiator is 90 wt% of the weight before the temperature increase). The 10 wt% reduction temperature of the photoinitiator is more preferably 210°C or higher, and still more preferably 220°C or higher. Examples of the photoinitiator having a 10 wt% reduction temperature in this range include: product names "Omnirad 369", "Omnirad 127", "Omnirad 379", and "Omnirad 819", manufactured by IGM Regins; product name "Irgacure OXE02" manufactured by BASF Japan; product name "ESACURE one" and "ESACURE 1001m" manufactured by Lamberti Group; and product names "ADEKA OPTOMER N-1414", "ADEKA OPTOMER N-1606", and "ADEKA OPTOMER N-1717" manufactured by ADEKA CORPORATION.

The pressure-sensitive adhesive layer containing a photoinitiator can be formed using a pressure-sensitive adhesive composition containing the photoinitiator. A method for incorporating a photoinitiator into the pressure-sensitive adhesive composition is not particularly limited. For example, it is preferable to add and mix a photoinitiator into the pressure-sensitive adhesive composition, typically into a liquid containing a polymer (a polymer in which polymerization has been completed). In this method, the photoinitiator may be added to the composition along with other added components (for example, a crosslinking agent). Examples of other methods include a method of adding a polymerization initiator capable of functioning as a photoinitiator during polymer polymerization. In this method, the polymerization initiator is added such that a predetermined amount remains after polymerization. The remaining amount of the polymerization initiator (amount of photoinitiator present) can be adjusted not only by adjusting the amount of polymerization initiator added, but also by adjusting polymer polymerization conditions, drying conditions and curing conditions when forming the pressure-sensitive adhesive layer, and the like.

In the case where the pressure-sensitive adhesive layer contains a photoinitiator, a content of the photoinitiator in the pressure-sensitive adhesive layer is not particularly limited and can be set so as to appropriately exhibit the desired effect. In some aspects, the content of the photoinitiator may be, for example, about 0.05 parts by weight or more, preferably about 0.1 parts by weight or more, and more preferably about 0.5 parts by weight or more, with respect to 100 parts by weight of the base polymer in the pressure-sensitive adhesive layer. By increasing the content of the photoinitiator, the active energy ray curability of the pressure-sensitive adhesive layer tends to improve. In some aspects, the content of the photoinitiator may be, for example, about 0.8 parts by weight or more, about 2.0 parts by weight or more, or about 2.5 parts by weight or more, with respect to 100 parts by weight of the base polymer. In addition, the content of the photoinitiator can be, for example, about 20 parts by weight or less, and is generally appropriately about 10 parts by weight or less, preferably about 8 parts by weight or less, may be about 6 parts by weight or less, or about 4 parts by weight or less, with respect to 100 parts by weight of the base polymer. A low content of photoinitiator is preferred from the viewpoint of storage stability of the pressure-sensitive adhesive layer and the pressure-sensitive adhesive sheet (for example, performance to prevent performance changes due to storage of the pressure-sensitive adhesive sheet before adhering to an adherend).

### (Irradiation Conditions)

Conditions for irradiation with an active energy ray are not particularly limited, and can be set so as to allow the curing of the pressure-sensitive adhesive layer to proceed appropriately. Those skilled in the art would be able to set appropriate irradiation conditions without undue burden based on the technical common sense in the field, so that detailed description is omitted. For example, in the case of using UV light as the active energy ray, UV irradiation conditions can be, for example, an integrated light amount in the range of about 50 mJ/cm² to 5,000 mJ/cm², in the range of about 50 mJ/cm² to 2,000 mJ/cm², or in the range of about 100 mJ/cm² to 2,000 mJ/cm², and an irradiation time in the range of about 1 second to 30 minutes.

### (Thermosetting Pressure-sensitive Adhesive Layer)

The thermosetting pressure-sensitive adhesive layer is typically cured by reacting thermosetting functional groups by heat to form a crosslinked structure. In order to promote the reaction of the thermosetting functional groups, the thermosetting pressure-sensitive adhesive layer may contain a curing catalyst, if necessary. For example, in a thermosetting pressure-sensitive adhesive layer having a carbon-carbon double bond (such as an ethylenically unsaturated group) as the thermosetting functional group, a known thermal polymerization initiator such as an azo-based polymerization initiator or a peroxide-based initiator can be contained as the curing catalyst. A composition of the thermosetting pressure-sensitive adhesive layer and conditions in a heat treatment as an adhesion force reducing means can be selected such that the adhesion force reducing effect of the heat treatment is appropriately exhibited.

The third aspect relates to an electrically debondable pressure-sensitive adhesive layer containing a polymer, an electrolyte, and at least one compound selected from the group consisting of a surfactant and a compound having a polyoxyalkylene skeleton, and a pressure-sensitive adhesive sheet including the electrically debondable pressure-sensitive adhesive layer.

Here, various suitable examples of the polymer, the electrolyte, and other optional components in the electrically debondable pressure-sensitive adhesive layer and the pressure-sensitive adhesive sheet according to the third aspect are as described above.

The electrically debondable pressure-sensitive adhesive layer and the pressure-sensitive adhesive sheet according to the third aspect contain at least one compound selected from the group consisting of a surfactant and a compound having a polyoxyalkylene skeleton (hereinafter, also referred to as a compound A or a peeling additive). When such a compound A (peeling additive) is contained in the pressure-sensitive adhesive layer, the peeling force reducing effect by supplying a peeling liquid can be suitably expressed. The reason for this is not to be interpreted in any particular way, and is thought to be that both the surfactant and the compound having a polyoxyalkylene skeleton have hydrophilic regions and are thus appropriately unevenly distributed on the surface of the pressure-sensitive adhesive layer, effectively reducing the peeling force during the contact with the peeling liquid.

In addition, the electrically debondable pressure-sensitive adhesive layer and the pressure-sensitive adhesive sheet according to the third aspect contain an electrolyte such as an ionic liquid, and therefore also have ability of electro-debonding.

As the peeling liquid, those containing a small amount of additive, if necessary, in water or a mixed solvent containing water as a main component can be used. As the solvent other than water constituting the above mixed solvent, a lower alcohol (for example, ethyl alcohol) or a lower ketone (for example, acetone) which can be uniformly mixed with water can be used. As the additive, known surfactants, pH adjusters, and the like can be used. In some aspects, a peeling liquid substantially free of an additive may be preferably used from the viewpoint of avoiding contamination of an adherend. It is particularly preferable to use water as the peeling liquid from the viewpoint of environmental health. The water is not particularly limited, and for example, distilled water, ion-exchanged water, or tap water can be used taking into consideration a purity required for applications and ease of availability.

In the case where the separation method disclosed here is performed in an aspect in which a peeling liquid is supplied, it is preferable to supply the peeling liquid to a peeling front of the pressure-sensitive adhesive sheet from the adherend. Here, in the present description, the peeling front refers to a location where the pressure-sensitive adhesive surface of the pressure-sensitive adhesive sheet begins to separate from the adherend as the peeling of the pressure-sensitive adhesive sheet from the adherend progresses. It is also preferable that, in a state where the peeling liquid is present at an interface between the adherend and the pressure-sensitive adhesive sheet at the peeling front of the pressure-sensitive adhesive sheet from the adherend, the pressure-sensitive adhesive sheet is peeled off from the adherend while the peeling liquid advances into the interface following the movement of the peeling front.

As the surfactant and the compound having a polyoxyalkylene skeleton, one or two or more of known surfactants and compounds having a polyoxyalkylene skeleton can be used without any particular limitation. Typically, the compound A is preferably contained in the pressure-sensitive adhesive layer in a free form. Note that, needless to say, among the above surfactants, there is a compound having a polyoxyalkylene skeleton, and vice versa.

As the surfactant that can be used as the compound A, a known nonionic surfactant, anionic surfactant, or cationic surfactant, and the like can be used. Among these, a nonionic surfactant is preferred. The surfactant may be used alone or in combination of two or more kinds thereof.

Examples of the nonionic surfactant include: polyoxyethylene alkyl ethers such as polyoxyethylene lauryl ether, polyoxyethylene cetyl ether, polyoxyethylene stearyl ether, and polyoxyethylene oleyl ether; polyoxyethylene alkylphenyl ethers such as polyoxyethylene octylphenyl ether and polyoxyethylene nonylphenyl ether; polyoxyethylene fatty acid esters such as polyoxyethylene monolaurate, polyoxyethylene monostearate, and polyoxyethylene monooleate; sorbitan fatty acid esters such as sorbitan monolaurate, sorbitan monopalmitate, sorbitan monostearate, and sorbitan monooleate; polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan tristearate, polyoxyethylene sorbitan triisostearate, polyoxyethylene sorbitan monooleate, and polyoxyethylene sorbitan trioleate; polyoxyethylene glyceryl ether fatty acid esters; and a polyoxyethylene-polyoxypropylene block copolymer. The nonionic surfactant may be a reactive surfactant having a radically polymerizable functional group such as a propenyl group, a (meth)allyl group, a vinyl group, or a (meth)acryloyl group (for example, a nonionic reactive surfactant such as polyoxyethylene nonylpropenyl phenyl ether). The nonionic surfactant may be used alone or in combination of two or more kinds thereof. From the viewpoint of suitably exhibiting the effect of the compound A being appropriately unevenly distributed on the surface of the pressure-sensitive adhesive layer and enhancing performance stability of the pressure-sensitive adhesive sheet, (nonreactive) nonionic surfactant that does not have a radically polymerizable functional group as described above can be preferably used.

Examples of the anionic surfactant include: alkylbenzene sulfonates such as a nonylbenzene sulfonate and a dodecylbenzene sulfonate (for example, sodium dodecylbenzene sulfonate); lauryl sulfates (for example, sodium lauryl sulfate and ammonium lauryl sulfate); alkyl sulfates such as octadecyl sulfate; fatty acid salts; polyoxyethylene alkyl ether sulfates such as a polyoxyethylene octadecyl ether sulfate and a polyoxyethylene lauryl ether sulfate (for example, sodium polyoxyethylene alkyl ether sulfate); polyoxyethylene alkyl phenyl ether sulfates such as a polyoxyethylene lauryl phenyl ether sulfate (for example, polyoxyethylene alkyl phenyl ether ammonium sulfate and sodium polyoxyethylene alkyl phenyl ether sulfate); polyether sulfates such as a polyoxyethylene styrenated phenyl ether sulfate; polyoxyethylene alkyl ether phosphate esters such as a polyoxyethylene stearyl ether phosphate ester and a polyoxyethylene lauryl ether phosphate ester; polyoxyethylene alkyl ether phosphates such as a sodium salt and a potassium salt of the above polyoxyethylene alkyl ether phosphate esters; sulfosuccinates such as a lauryl sulfosuccinate and a polyoxyethylene lauryl sulfosuccinate (for example, sodium polyoxyethylene alkyl sulfosuccinate); and polyoxyethylene alkyl ether acetates. In the case where the anionic surfactant forms a salt, the salt may be, for example, a metal salt (preferably a salt of a monovalent metal), such as a sodium salt, a potassium salt, a calcium salt, and a magnesium salt, an ammonium salt, or an amine salt. The anionic surfactant may be used alone or in combination of two or more kinds thereof. From the same viewpoint as for the nonionic surfactants, a nonreactive anionic surfactant can be preferably used.

Examples of the cationic surfactant include polyetheramines such as polyoxyethylene laurylamine and polyoxyethylene stearylamine. The cationic surfactant may be used alone or in combination of two or more kinds thereof.

As the compound having a polyoxyalkylene skeleton that can be used as the compound A, for example, polyalkylene glycols such as polyethylene glycol (PEG) and polypropylene glycol (PPG); polyethers having a polyoxyethylene unit, polyethers having a polyoxypropylene unit, and a compound having an oxyethylene unit and an oxypropylene unit (arrangement of these units may be random or in blocks); and a derivatives thereof can be used. Among the above nonionic, anionic and cationic surfactants, the compound having a polyoxyalkylene skeleton can also be used. These compound may be used alone or in combination of two or more kinds thereof. Among these, it is preferable to use a compound having a polyoxyethylene skeleton (also called a polyoxyethylene segment), and it is more preferable to use PEG.

A molecular weight (chemical formula weight) of the compound having a polyoxyalkylene skeleton (for example, polyethylene glycol) is not particularly limited. For example, the molecular weight is appropriately less than 1000, and preferably about 600 or less (for example, 500 or less) from the viewpoint of uniform mixability. The compound having a polyoxyalkylene skeleton (for example, polyethylene glycol) is not particularly limited in lower limit of the molecular weight, and those having a molecular weight of about 100 or more (for example, about 200 or more, or even about 300 or more) are preferably used.

The pressure-sensitive adhesive layer containing the compound A is typically formed from a pressure-sensitive adhesive composition containing the compound A. The pressure-sensitive adhesive composition containing the compound A can be preferably prepared by a method including adding the compound A in a solvent-free form or in the form of a solution in an organic solvent. The above solvent-free form refers to a form that is not diluted with water or an organic solvent that does not form a pressure-sensitive adhesive layer, and can be, for example, a form formed of the compound A. The organic solvent used in preparing the organic solvent solution can be appropriately selected from known organic solvents. Specific examples of such an organic solvent include solvents same as those used in solution polymerization to be described later. Suitable examples include ethyl acetate, a mixed solvent containing ethyl acetate (which may be a mixed solvent of ethyl acetate and toluene), toluene, a mixed solvent containing toluene. For example, ethyl acetate or a mixed solvent containing ethyl acetate as a main component can be preferably used. In the case of a solvent-based or active energy ray curable pressure-sensitive adhesive composition, in some aspects, it is preferable to add the compound A in the form of an organic solvent solution substantially free of water (for example, a content of water is less than 10 parts by weight, less than 5 parts by weight, or less than 1 part by weight with respect to 100 parts by weight of the compound A), from the viewpoint of preventing water from being brought into the pressure-sensitive adhesive composition. Accordingly, a more uniform pressure-sensitive adhesive layer can be formed.

In some aspects, as the compound A, a nonionic compound is preferably used since it can be easily blended uniformly in the pressure-sensitive adhesive composition. A pressure-sensitive adhesive composition in which the compound A is uniformly blended tends to form a pressure-sensitive adhesive layer in which the compound A is uniformly present on the surface. This is preferred from the viewpoint of allowing the peeling of the pressure-sensitive adhesive sheet from the adherend to proceed more smoothly, and reducing a load on the adherend caused by a fluctuation in peeling force (for example, vibration and impact associated with the fluctuation).

An HLB of the compound A is not particularly limited. The HLB of the compound A can be, for example, 1 or more, or 3 or more. The HLB of the compound A is preferably 5 or more, and may be 6 or more, 8 or more, or 9 or more. Accordingly, water peelability tends to be preferably expressed. The HLB of the compound A is more preferably 10 or more, still more preferably 11 or more, even more preferably 12 or more, particularly preferably 13 or more, and may be 14 or more, 15 or more, or even 16 or more. With the compound A having an HLB in the above range, it is possible to more effectively express low peelability by water peeling. An upper limit of the HLB is 20 or less, and may be, for example, 18 or less. In some aspects, the HLB of the compound A may be 16 or less, for example, 15 or less, from the viewpoint of compatibility, for example.

Note that, in the present description, the HLB is a hydrophile-lipophile balance according to Griffin, which is a numerical value indicating the degree of affinity of a surfactant for water or oil, and is a ratio of hydrophilicity to lipophilicity expressed as a number between 0 and 20. The definition of the HLB is as described in W. C. Griffin: J. Soc. Cosmetic Chemists, 1,311 (1949), and in "Surfactant Handbook," 3rd Edition, published by Kougakutosho Ltd., November 25, 1972, pp. 179-182, co-authored by Takahashi Etsutami, Nanba Yoshiro, Koike Motoo, and Kobayashi Masao. The compound A having the above HLB can be selected based on the technical common sense of those skilled in the art, for example by referring to the above references if necessary.

In some aspects, the compound A preferably has two or more hydroxy groups in one molecule, and more preferably has three or more hydroxy groups in one molecule, from the viewpoint of affinity with the peeling liquid. Examples of the compound A having two or three or more hydroxy groups in one molecule include a sorbitan monoester, a polyoxyalkylene sorbitan monoester, a polyoxyalkylene glyceryl ether, a polyoxyalkylene diglyceryl ether, and a polyoxyalkylene glyceryl ether monoester. An upper limit of the number of hydroxy groups that the compound A has in one molecule is not particularly limited, and is generally appropriately 10 or less, preferably 8 or less, and may be 6 or less, or 4 or less, from the viewpoint of solubility in an organic solvent and ease of preparation of the pressure-sensitive adhesive composition.

In some aspects, as the compound A, a nonionic compound having a fatty acid ester structure can be preferably selected from the viewpoint of the solubility in an organic solvent (for example, esters such as ethyl acetate). The compound A having a fatty acid ester structure can also be advantageous in terms of compatibility within the pressure-sensitive adhesive layer. For example, as the compound A to be contained in an acrylic pressure-sensitive adhesive layer, one having a fatty acid ester structure can be preferably used. Examples of the nonionic compound having a fatty acid ester structure include a sorbitan fatty acid ester, a polyoxyalkylene fatty acid ester, and a polyoxyalkylene fatty acid monoester.

In some aspects, the compound A is preferably one that is in a liquid state at room temperature (here, 25°C) in the form of 100% solid content, from the viewpoint of the ease of preparation of the organic solvent solution.

In addition, in some aspects, the compound A is preferably one that dissolves without phase separation in the following Test II, and more preferably one that dissolves without phase separation in the following Test I. Note that, the following tests I and II are carried out using the compound A in the form of 100% solid content in a room temperature (23°C to 25°C) environment.

### [Test I]

Ethyl acetate (90 g) and 10 g of the compound A are charged into a 200 milliliter (mL) container, followed by stirring with a glass rod for 1 minute and allowing to stand, and after 5 minutes, visual observation is performed for the presence or absence of phase separation.

### [Test II]

Ethyl acetate (90 g) and 10 g of the compound A are charged into a 200 mL container, followed by stirring with a glass rod for 1 minute, then a treatment using an ultrasonic disperser at 35 kHz for 10 minutes, further stirring with a glass rod for 1 minute, and allowing to stand, and after 5 minutes, visual observation is performed for the presence or absence of phase separation.

Note that, as the ultrasonic disperser, a model name "ULTRASONIC CLEANER" manufactured by AS ONE or an equivalent product can be used.

A usage amount of the compound A is not particularly limited, and can be set such that a reduction in peeling force due to the supply of the peeling liquid is effectively expressed. In some aspects, the usage amount of the compound A with respect to 100 parts by weight of the base polymer may be, for example, about 5 parts by weight or less, and is generally appropriately about 3 parts by weight or less, preferably less than 2 parts by weight, more preferably less than 1 part by weight, and may be less than 0.8 parts by weight, less than 0.6 parts by weight, less than 0.4 parts by weight, less than 0.2 parts by weight, or less than 0.1 parts by weight, from the viewpoint of adhesion reliability to the adherend and water resistance reliability at the stage where peeling is not intended. The compound A having a high HLB (for example, 5 or more, preferably 10 or more) tends to exhibit good peelability even when added in a small amount. In addition, the amount of the compound A with respect to 100 parts by weight of the base polymer can be, for example, 0.001 parts by weight or more, and is generally appropriately 0.01 parts by weight or more, and preferably 0.03 parts by weight or more (for example, 0.1 parts by weight or more), from the viewpoint of causing the compound A to be uniformly present on the surface of the pressure-sensitive adhesive layer and allowing the peeling of the pressure-sensitive adhesive sheet from the adherend to proceed more smoothly. In a composition where water peelability is important, the amount of the compound A with respect to 100 parts by weight of the base polymer may be 0.3 parts by weight or more (for example, 0.5 parts by weight or more).

### <Fixing Member>

The fixing member 2 is, for example, a plate-like member, but the shape, the structure, and the like thereof are not particularly limited. The fixing member 2 may be, for example, an electrically conductive film or an electrically conductive substrate such as an aluminum foil or a metal vapor deposition film. A material of the fixing member 2 is not particularly limited, and the fixing member 2 may be an electrically conductive material or an insulating material. However, in the present embodiment, since a positive electrode for applying a voltage is provided on the fixing member 2 as to be described later, it is desirable for the fixing member 2 to be formed of an electrically conductive material, for example, a metal. Therefore, the fixing member 2 may play a role of passing a current through the electrically debondable pressure-sensitive adhesive layer 1 and supporting the electrically debondable pressure-sensitive adhesive layer 1.

### <Inspection Target>

In the present embodiment, the inspection target to be subjected to the electrical conductivity inspection method includes the electrical conductor 3 and the insulator 4, and is expected to be a capacitor, but other types of electronic components are also to be subjected to inspection method. Electronic components that can be used as the inspection target include, but are not particularly limited to, a capacitor, an inductor, a chip, a resistor, a coil, a diode, a board, and a switch. In addition, electrically conductive material molded products such as a screw, molded products of an electrically conductive treated material, and molded products of an insulating treated material, in which electrical conductivity is important, can also be the inspection target to be subjected to the electrical conductivity inspection method. The molded products of the electrically conductive treated material and the molded products of the insulating treated material may include a surface treated material.

### <Details of Electrical Conductivity Inspection Method>

In the electrical conductivity inspection method according to the present embodiment, first, the electrical conductor 3 or the insulator 4 as an inspection target is joined to the fixing member 2 using the electrically debondable pressure-sensitive adhesive layer 1 capable of joining the inspection target and the fixing member 2, as shown on the left side in Fig. 1.

Next, a voltage is applied to the electrically debondable pressure-sensitive adhesive layer 1 via the inspection target and the fixing member using a predetermined voltage application device, as shown in the left side in Fig. 1. The voltage application device includes a positive electrode 5 and a negative electrode 6 for applying a voltage. In the present embodiment, the positive electrode 5 is connected to the fixing member 2, and the negative electrode 6 is connected to the electrical conductor 3 or the insulator 4, which is the inspection target. The electrodes are connected to the fixing member 2 and the inspection target via a probe, for example. By providing the electrodes in this manner, a voltage is applied from the fixing member 2 towards the inspection target, and in the case where the inspection target is the electrical conductor 3, a current flows in this direction.

After the voltage is applied, whether the inspection target is good or bad is determined according to the joining state between the inspection target and the fixing member 2, as shown in the right side in Fig. 1. Specifically, in the case where the inspection target is the electrical conductor 3, since the adhesion force of the electrically debondable pressure-sensitive adhesive layer 1 decreases due to the passage of the current, the inspection target is easier to separate from the fixing member 2, and will separate under certain conditions. On the other hand, in the case where the inspection target is the insulator 4, since no current is passed through the electrically debondable pressure-sensitive adhesive layer 1, the adhesion force of the electrically debondable pressure-sensitive adhesive layer 1 is maintained, and the joining state between the inspection target and the fixing member 2 does not change.

By observing such a change in adhesion force due to the passage of the current and the change in the joining state that accompany such a change in adhesion force, the tester can determine whether the inspection target is an electrical conductor or an insulator. Therefore, it is possible to easily determine whether the inspection target is an electrical conductor or an insulator without measuring values such as a current value or a resistance value of the inspection target.

In addition, the present embodiment is also applicable to inspection of whether an electrical conductor is a non-defective product, and to inspection of whether an insulator is a non-defective product. In the case where a predetermined voltage is applied to an electrical conductor, when the electrical conductor is a non-defective product, a current equal to or greater than a threshold value flows, so that the electrical conductor is more likely to separate from the fixing member 2 and is expected to separate under certain conditions. In the case where a particular electrical conductor does not separate even under such conditions, the electrical conductor can be determined to be a defective product since an expected current does not flow therethrough. On the other hand, in the case where a predetermined voltage is applied to an insulator, when the insulator is a non-defective product, zero current or only a current less than a threshold value flows, so that the joining state between the electrical conductor and the fixing member 2 is expected to be maintained. In the case where a particular insulator separates even under such conditions, the insulator can be determined to be a defective product since an unexpected current therethrough.

That is, the electrical conductivity inspection method according to the present embodiment can efficiently determine the electrically conductive property of the inspection target based on the behavior of the inspection target during the inspection. In the case where it is not clear whether the inspection target is an electrical conductor or an insulator, the tester can determine whether the inspection target is an electrical conductor or an insulator based on the behavior of the inspection target. In addition, whether the inspection target is an electrical conductor or an insulator, the tester can determine whether the inspection target is a non-defective product or a defective product based on the behavior of the inspection target.

Note that, although the number of inspection targets to be inspected at one time may be one, the inspection can be carried out more efficiently by inspecting a plurality of inspection targets at once.

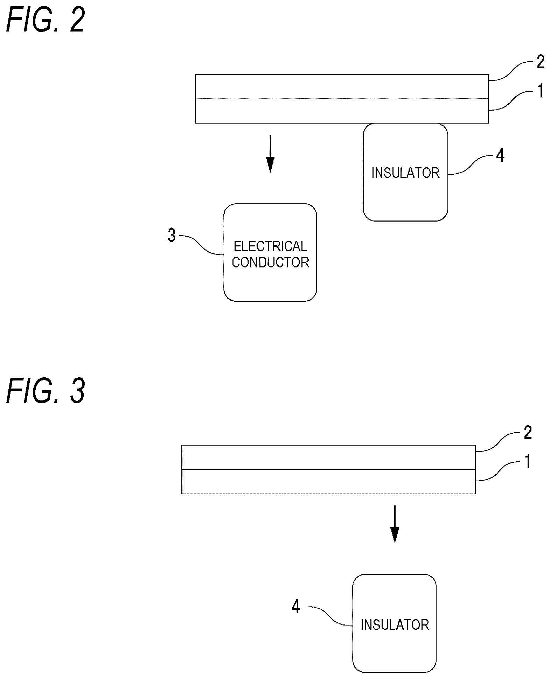

Further, the electrical conductivity inspection method according to the present embodiment can also classify and separate the inspection target at the same time as the electrically conductive property of the inspection target is determined. The classification and separation method is not particularly limited. For example, as shown in Fig. 2, by disposing all the members upside down with respect to the state shown in Fig. 1 and applying a voltage, only the inspection target separated from the fixing member 2 drops due to the own weight, and the dropped inspection target can be classified and separated. The adhesive force of the electrically debondable pressure-sensitive adhesive layer 1 to an adherend decreases when a voltage is applied. Therefore, as shown in Fig. 2, the inspection target that drops from the electrically debondable pressure-sensitive adhesive layer 1 after the voltage is applied can be determined to be an electrical conductor 3 or a non-defective electrical conductor 3. On the other hand, as shown in Fig. 2, the inspection target remaining on the electrically debondable pressure-sensitive adhesive layer 1 after the voltage is applied can be determined to be an insulator 4 or a non-defective insulator 4. In addition, the classification and separation can also be performed by applying an external force such as wind or vibration to the inspection target instead of the own weight, i.e., gravity, or the classification and separation can also be performed by pressing a separately prepared pressure-sensitive adhesive tape against the inspection target and determining whether it can be separated from the electrically debondable pressure-sensitive adhesive layer 1. Accordingly, it is also possible to efficiently classify and separate the inspection target. Further, for example, when a tray provided with an impact absorbing material on a bottom surface is prepared at a drop position of the electrical conductor 3 shown in Fig. 2, the classified and separated inspection target can be collected without being damaged. Instead of using the tray, the classified and separated inspection target may be collected by a belt conveyor or the like.

In addition, in the present embodiment, the electrically debondable pressure-sensitive adhesive layer 1 has a single layer structure, the positive electrode 5 for applying a voltage is connected to the fixing member 2, and the negative electrode 6 for applying a voltage is connected to the inspection target. Accordingly, the electrical conductivity inspection method can be carried out with a simple configuration.

### <Separation Method of Inspection Target>

Further, in the electrical conductivity inspection method according to the present embodiment, after applying a voltage to the inspection target and the electrically debondable pressure-sensitive adhesive layer 1, a predetermined energy other than electricity or a predetermined substance may be supplied to the electrically debondable pressure-sensitive adhesive layer 1. Accordingly, the electrically conductive property of the inspection target can be determined, and in the inspection target, the remaining inspection target joined to the electrically debondable pressure-sensitive adhesive layer 1 after the voltage is applied can be separated.

In the example shown in Fig. 2, as a result of applying a voltage to the inspection target and the electrically debondable pressure-sensitive adhesive layer 1, the electrical conductor 3 drops and the insulator 4 is joined to the electrically debondable pressure-sensitive adhesive layer 1, with the insulator 4 corresponding to the remaining inspection target. In the state shown in Fig. 2 where only the insulator 4 is joined to the electrically debondable pressure-sensitive adhesive layer 1, when a predetermined energy other than electricity or a predetermined substance is supplied to the electrically debondable pressure-sensitive adhesive layer 1, the adhesion property of the electrically debondable pressure-sensitive adhesive layer 1 can be lowered. As a result, as shown in Fig. 3, the insulator 4 joined to the electrically debondable pressure-sensitive adhesive layer 1 after the voltage is applied is separated from the electrically debondable pressure-sensitive adhesive layer 1. In the example shown in Fig. 3, the remaining inspection target drops from the electrically debondable pressure-sensitive adhesive layer 1 having a lowered adhesion property due to the own weight, and is thereby separated from the electrically debondable pressure-sensitive adhesive layer 1. The remaining inspection target may be separated by applying, for example, an external force such as wind or vibration to the inspection target joined to the electrically debondable pressure-sensitive adhesive layer 1 after the voltage is applied, or by pressing a pressure-sensitive adhesive tape against the inspection target.

In the case where the electrically debondable pressure-sensitive adhesive layer 1 is the first aspect described above, or an electrically debondable pressure-sensitive adhesive layer, which is cured by heating in the second aspect, the electrically debondable pressure-sensitive adhesive layer 1 can be heated to lower the adhesion property of the electrically debondable pressure-sensitive adhesive layer 1, thereby making it possible to separate the remaining inspection target. In the case where the electrically debondable pressure-sensitive adhesive layer 1 is cured by irradiation with an active energy ray in the second aspect described above, the electrically debondable pressure-sensitive adhesive layer 1 is irradiated with the active energy ray to lower the adhesion property of the electrically debondable pressure-sensitive adhesive layer 1, thereby making it possible to separate the remaining inspection target. In the case where the electrically debondable pressure-sensitive adhesive layer 1 is the third aspect described above, water or an alcohol is supplied to the electrically debondable pressure-sensitive adhesive layer 1 to lower the adhesion property of the electrically debondable pressure-sensitive adhesive layer 1, thereby making it possible to separate the remaining inspection target.

In the present embodiment, the remaining inspection target separated from the electrically debondable pressure-sensitive adhesive layer 1 by supplying a predetermined energy other than electricity or a predetermined substance can be collected on a tray or the like. In addition, for example, when the inspection target separated from the electrically debondable pressure-sensitive adhesive layer 1 after the voltage is applied is collected in a first tray, and the inspection target separated from the electrically debondable pressure-sensitive adhesive layer 1 after a predetermined energy other than electricity or a predetermined substance is supplied is collected in a second tray, the tester can subsequently determine the electrically conductive property of the inspection targets.

### (Second Embodiment)

### <Outline of Electrical Conductivity Inspection Method>

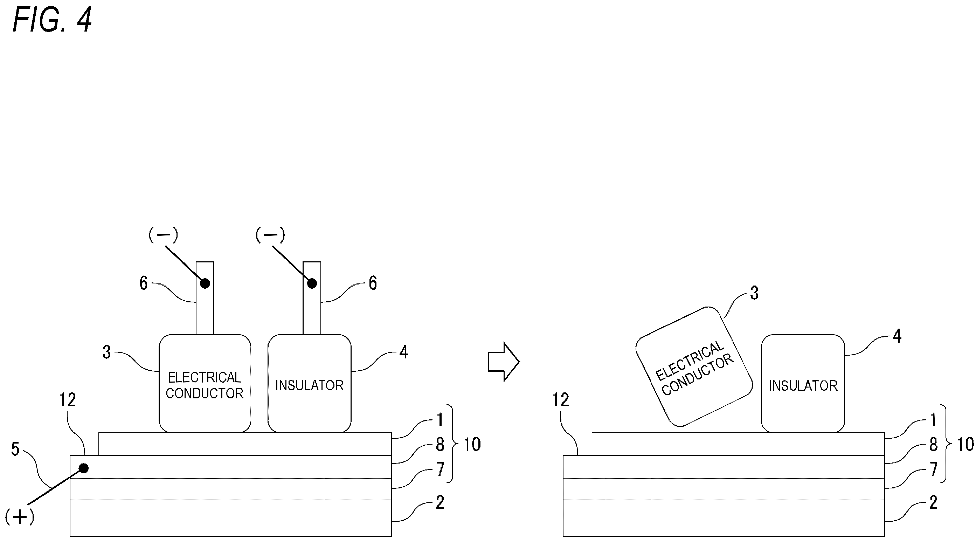

Fig. 4 is a diagram schematically illustrating a process of an electrical conductivity inspection method according to a second embodiment of the present invention. The present embodiment has the same basic content as the first embodiment, but a pressure-sensitive adhesive layer 7 and an electrically conductive layer 8 are further disposed between the electrically debondable adhesive layer 1 and the fixing member 2. As viewed from a fixing member 2 side, the pressure-sensitive adhesive layer 7, the electrically conductive layer 8, and the electrically debondable pressure-sensitive adhesive layer 1 are laminated in this order. It can also be said that an electrically debondable pressure-sensitive adhesive sheet 10 including three layers, i.e., the pressure-sensitive adhesive layer 7, the electrically conductive layer 8, and the electrically debondable pressure-sensitive adhesive layer 1, is disposed between the fixing member 2 and the inspection target (the electrical conductor 3 or the insulator 4). The electrically debondable pressure-sensitive adhesive sheet 10 is capable of joining the fixing member 2 and the inspection target by functions of the pressure-sensitive adhesive layer 7 and the electrically debondable pressure-sensitive adhesive layer 1.

In the present embodiment, the positive electrode 5 for applying a voltage is connected to the electrically conductive layer 8, and the negative electrode 6 for applying a voltage is connected to the inspection target. Therefore, the fixing member 2 does not necessarily have electrical conductivity, and plays only a role of supporting the electrically debondable pressure-sensitive adhesive sheet 10. In addition, the electrically debondable pressure-sensitive adhesive sheet 10 has a cutout portion 12 formed by removing a part, particularly an edge portion, of the electrically debondable pressure-sensitive adhesive layer 1. Therefore, for example, by bringing a probe into contact with the cutout portion 12, electrical connection can be easily made between the positive electrode 5 and the electrically conductive layer 8.

### <Pressure-sensitive Adhesive Layer>

The pressure-sensitive adhesive layer 7 contains a polymer for expressing an adhesion property to the pressure-sensitive adhesive layer 7. As the pressure-sensitive adhesive layer 7, those described as "another pressure-sensitive adhesive layer" in the first embodiment can be used directly.

### <Electrically Conductive Layer>

The electrically conductive layer 8 is not particularly limited as long as it has an electrically conductive layer, and the "electrically conductive layer" described in the first embodiment can be used directly. The electrically conductive layer 8 may have a single layer structure as shown in Fig. 4, or may be used in the form of a laminated structure (conduction substrate) including an electrically conductive layer and a substrate. As the conduction substrate having a laminated structure including an electrically conductive layer and a substrate, those described as the "conduction substrate" in the first embodiment can be used directly.

### <Details of Electrical Conductivity Inspection Method and Separation method>

In the electrical conductivity inspection method according to the present embodiment, first, the electrical conductor 3 or the insulator 4 as an inspection target is joined to the fixing member 2 using the electrically debondable pressure-sensitive adhesive sheet 10 capable of joining the inspection target and the fixing member 2, as shown on a left side in Fig. 4.

Next, a voltage is applied to the inspection target and the electrically debondable pressure-sensitive adhesive layer 1 of the electrically debondable pressure-sensitive adhesive sheet 10 using a predetermined voltage application device, as shown in the left side in Fig. 4. In the present embodiment, a voltage is applied to the electrically debondable pressure-sensitive adhesive layer 1 via the inspection target and the electrically conductive layer 8 of the electrically debondable pressure-sensitive adhesive sheet 10. The voltage application device includes the positive electrode 5 and the negative electrode 6 for applying a voltage. In the present embodiment, the positive electrode 5 is connected to the electrically conductive layer 8 of the electrically debondable pressure-sensitive adhesive sheet 10, and the negative electrode 6 is connected to the electrical conductor 3 or the insulator 4, which is the inspection target. The electrodes are connected to the electrically conductive layer 8 and the inspection target via a probe, for example. By providing the electrodes in this manner, a voltage is applied from the electrically conductive layer 8 towards the inspection target, and in the case where the inspection target is the electrical conductor 3, a current flows in this direction.

After the voltage is applied, whether the inspection target is good or bad is determined according to the joining state between the inspection target and the fixing member 2. The subsequent determination is the same as in the first embodiment.

In addition, in the present embodiment, the electrically debondable pressure-sensitive adhesive sheet 10 having a three layer structure in which the pressure-sensitive adhesive layer 7 and the electrically conductive layer 8 are disposed in addition to the electrically debondable pressure-sensitive adhesive layer 1 is used. Accordingly, the electrical conductivity inspection method can be carried out in a state where the inspection target is securely joined to the fixing member 2. In addition, an insulator can be used as the fixing member 2.

Further, in the present embodiment, similar to the first embodiment, after applying a voltage to the inspection target and the electrically debondable pressure-sensitive adhesive layer 1 of the electrically debondable pressure-sensitive adhesive sheet 10, a predetermined energy other than electricity or a predetermined substance may also be supplied to the electrically debondable pressure-sensitive adhesive layer 1. Accordingly, the electrically conductive property of the inspection target can be determined, and in the inspection target, the remaining inspection target joined to the electrically debondable pressure-sensitive adhesive layer 1 after the voltage is applied can be separated. Further, the separated remaining inspection target can be collected.

Note that, the present invention is not limited to the embodiments described above, and modifications, improvements, and the like can be made as appropriate. Materials, shapes, sizes, numerical values, forms, numbers, arrangement locations, and the like of components in the embodiments described above are set as desired and are not limited as long as the present invention can be achieved.

### (Supplementary Description)

Here, the characteristics of the electrical conductivity inspection method, the separation method, the electrically debondable pressure-sensitive adhesive layer, and the pressure-sensitive adhesive sheet according to the above embodiments of the present invention will be briefly summarized and listed below in [1] to [20].
[1] An electrical conductivity inspection method including:
   joining an inspection target and a fixing member together using an electrically debondable pressure-sensitive adhesive layer capable of joining the inspection target and the fixing member;
   applying a voltage to the inspection target and the electrically debondable pressure-sensitive adhesive layer; and
   determining an electrically conductive property of the inspection target according to a joining state between the inspection target and the fixing member after the voltage is applied.
[2] The electrical conductivity inspection method according to the above [1], in which it is determined whether the inspection target is an electrical conductor or an insulator based on the electrically conductive property of the inspection target.
[3] The electrical conductivity inspection method according to the above [1], in which it is determined whether the inspection target is a non-defective product or a defective product based on the electrically conductive property of the inspection target.
[4] The electrical conductivity inspection method according to any one of the above [1] to [3], in which the inspection target is classified and separated at a same time as the electrically conductive property of the inspection target is determined.
[5] The electrical conductivity inspection method according to any one of the above [1] to [4], in which
   the fixing member has electrical conductivity, and
   a voltage is applied to the electrically debondable pressure-sensitive adhesive layer via the inspection target and the fixing member.
[6] The electrical conductivity inspection method according to any one of the above [1] to [5], in which
   the electrically debondable pressure-sensitive adhesive layer has a single layer structure,
   the fixing member has electrical conductivity, and
   a positive electrode for applying a voltage is connected to the fixing member, and a negative electrode for applying a voltage is connected to the inspection target.
[7] The electrical conductivity inspection method according to any one of the above [1] to [6], in which a voltage is applied to the electrically debondable pressure-sensitive adhesive layer via the inspection target and an electrically conductive layer, in a state where a pressure-sensitive adhesive layer and an electrically conductive layer are further disposed between the electrically debondable pressure-sensitive adhesive layer and the fixing member.
[8] The electrical conductivity inspection method according to the above [7], in which a positive electrode for applying a voltage is connected to the electrically conductive layer, and a negative electrode for applying a voltage is connected to the inspection target.
[9] The electrical conductivity inspection method according to any one of the above [1] to [8], in which the electrically debondable pressure-sensitive adhesive layer contains an electrolyte.
[10] The electrical conductivity inspection method according to any one of the above [1] to [9], in which the electrically debondable pressure-sensitive adhesive layer contains an ionic liquid.
[11] The electrical conductivity inspection method according to the above [10], in which an anion in the ionic liquid is at least one anion selected from the group consisting of (FSO₂)₂N⁻, (CF₃SO₂)₂N⁻, (CF₃CF₂SO₂)₂N⁻, (CF₃SO₂)₃C⁻, CH₃COO⁻, CF₃COO⁻, CF₃CF₂CF₂COO⁻, CF₃SO₃⁻, CF₃(CF₂)₃SO₃⁻, Br⁻, AlCl₄⁻, Al₂Cl₇⁻, NO₃⁻, BF₄⁻, PF₆⁻, AsF₆⁻, SbF₆⁻, and F(HF)ₙ⁻ (n represents an integer of 1 or more).
[12] A separation method in the electrical conductivity inspection method according to any one of the above [1] to [11], the method including:
   after applying a voltage to the inspection target and the electrically debondable pressure-sensitive adhesive layer,
   supplying a predetermined energy other than electricity or a predetermined substance to the electrically debondable pressure-sensitive adhesive layer; and
   determining an electrically conductive property of the inspection target, and separating a remaining inspection target joined to the electrically debondable pressure-sensitive adhesive layer after the voltage is applied.
[13] The separation method according to the above [12], in which the remaining inspection target is an insulator.
[14] The separation method according to the above [12] or [13], in which heat is supplied as the predetermined energy to the electrically debondable pressure-sensitive adhesive layer.
[15] The separation method according to the above [12] or [13], in which an active energy ray is supplied as the predetermined energy to the electrically debondable pressure-sensitive adhesive layer.
[16] The separation method according to any one of the above [12] to [15], in which after applying a voltage to the inspection target and the electrically debondable pressure-sensitive adhesive layer, the electrically conductive property of the inspection target is determined, and then the predetermined energy other than electricity or the predetermined substance is supplied to the electrically debondable pressure-sensitive adhesive layer to separate the remaining inspection target.
[17] An electrically debondable pressure-sensitive adhesive layer containing:
   a polymer;
   an electrolyte; and
   a thermally expandable filler.
[18] An electrically debondable pressure-sensitive adhesive laye, which is cured by irradiation with an active energy ray or by heating, containing:
   a polymer; and
   an electrolyte.
[19] An electrically debondable pressure-sensitive adhesive layer containing:
   a polymer;
   an electrolyte; and
   at least one compound selected from the group consisting of a surfactant and a compound having a polyoxyalkylene skeleton.
[20] A pressure-sensitive adhesive sheet including:
   the electrically debondable pressure-sensitive adhesive layer according to any one of the above [17] to [19].

### Examples

Hereinafter, the present invention will be more specifically described by Examples; however, the present invention is not limited by these Examples.

### [Examples 1 and 2 and Comparative Example 1]

### <Polymer>

### (Preparation of Acrylic Polymer 1 Solution)

Into a separable flask were charged 87 parts by mass of n-butyl acrylate (BA), 10 parts by mass of 2-methoxyethyl acrylate (MEA), and 3 parts by mass of acrylic acid (AA) as monomer components, and 150 parts by mass of ethyl acetate as a polymerization solvent, followed by stirring for 1 hour while introducing a nitrogen gas. After oxygen in the polymerization system was removed in this manner, 0.2 parts by mass of 2,2'-azobisisobutyronitrile (AIBN) was added as a polymerization initiator, and the mixture was heated to 63°C and allowed to react for 6 hours. Thereafter, ethyl acetate was added to obtain an acrylic polymer 1 solution having a solid content concentration of 40 mass%. The obtained acrylic polymer 1 had a weight average molecular weight of 750,000.

### <Preparation of Pressure-sensitive adhesive Composition>

Respective components, i.e., the obtained acrylic polymer solution, a solution of each tackifier in ethyl acetate adjusted to have a solid content concentration of 50 mass%, and a crosslinking agent, an ionic liquid, and a thermally expandable filler shown below in Table 1 were stirred and mixed to obtain electrically debondable pressure-sensitive adhesive compositions (solutions) in Examples 1 and 2 and Comparative Example 1 each adjusted to have a solid content concentration of 25 mass%. Note that, ethyl acetate was used to adjust the solid content concentration of the pressure-sensitive adhesive composition. Blending amounts of the respective components are shown in Table 1.

Note that, a value of each component in Table 1 means parts by mass. In addition, the blending amounts (parts by mass) of the polymer and the tackifier each indicate a blending amount (parts by mass) of a solid content.

### <Preparation of Electrically Debondable Type Pressure-sensitive adhesive Layer>

The obtained electrical debondable pressure-sensitive adhesive composition (solution) was applied using an applicator onto a release-treated surface of a polyethylene terephthalate release liner (product name: "MRF38", manufactured by Mitsubishi Chemical Corporation) whose surface was subjected to a release-treatment so as to have a uniform thickness. Next, heating and drying were performed at 80°C for 5 minutes, and the release-treated surface of the polyethylene terephthalate release liner (product name: "MRE38", manufactured by Mitsubishi Chemical Corporation) whose surface was subjected to a release-treatment was laminated on a pressure-sensitive adhesive layer using a hand roller. Thereafter, the obtained laminate was heated at 50°C for 48 hours to obtain an electrically debondable type pressure-sensitive adhesive layer having a thickness of 60 µm.

### <Preparation of Substrate-adhered Single-sided Pressure-sensitive Adhesive Sheet>

The obtained electrically debondable type pressure-sensitive adhesive layer was made into a sheet having a size of 10 mm × 80 mm, the release liner (MRE38) was peeled off, and a surface on a metal layer side of a metal layer-attached film (product name: "1005CR", manufactured by Toray Industries, Inc., thickness: 12 µm, size: 10 mm × 100 mm) was adhered to an exposed surface of the electrically debondable type pressure-sensitive adhesive layer to obtain a substrate-adhered single-sided pressure-sensitive adhesive sheet.

### <Preparation of Joined Body>

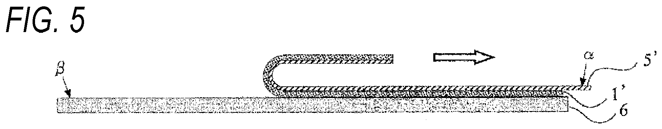

A release liner (MRF38) of the substrate-adhered single-sided pressure-sensitive adhesive sheet was peeled off, and a stainless steel plate as an adherend was adhered to the surface subjected to peeling such that one end of the pressure-sensitive adhesive sheet protruded from the adherend by about 2 mm, and the obtained laminate was pressed back and forth once with a 2 kg roller, followed by standing in an environment of 23°C for 30 minutes, to obtain a joined body composed of a stainless steel plate 6/an electrically debondable type pressure-sensitive adhesive layer 1'/a metal layer-attached film (conduction substrate) 5'. An outline of the joined body is shown in Fig. 5.

### <Evaluation>

### (General Peeling Force)

A 180° peeling force test was performed using the joined bodies in Examples and Comparative Examples. The adherend material used was a stainless steel plate (SUS304, size: 30 mm × 120 mm).

Peeling was performed in an arrow direction in Fig. 5 using a peel tester (product name: "variable angle peel tester YSP", manufactured by ASAHI SEIKO CO., LTD.), an adhesive force in the 180° peel test (tensile speed: 300 mm/min, peeling temperature: 23°C) was measured, and a 180° peeling force was measured and taken as a general peeling force.

The measurement results are shown in Table 1. The unit of the general peeling force shown in Table 1 is N/cm.

### (Electrical Peeling Force)

A stainless steel plate (SUS304, size: 30 mm × 120 mm) was used as an adherend material. The joined body was prepared by pressing the stainless steel plate back and forth once with a 2 kg roller, following by standing in an environment of 23°C for 30 minutes. Thereafter, before peeling, electrodes, i.e., a negative electrode and a positive electrode, of a direct current machine were respectively attached to the joined body at portions of α and β in Fig. 5, and a voltage was applied for 30 seconds at a voltage of 30 V Immediately after the voltage application was stopped, peeling was performed in the same manner as in the above general peeling force measurement, and the adhesive force during the voltage application was measured and taken as an electrical peeling force.

Note that, a case where the electrical peeling force was 0.5 N/cm or less was evaluated as A, and a case where the electrical peel force was more than 0.5 N/cm was evaluated as B. The measurement results are shown in Table 1.

### (Thermal Peeling Force)

A stainless steel plate (SUS304, size: 30 mm × 120 mm) was used as an adherend material. The joined body was prepared by pressing the stainless steel plate back and forth once with a 2 kg roller, following by standing in an environment of 23°C for 30 minutes, and then, before peeling, the stainless steel plate side was heated at 150°C for 60 seconds using a hot stirrer. Immediately thereafter, peeling was performed in the same manner as in the above general peeling force measurement, and the adhesive force was measured and taken as a thermal peeling force.

Note that, a case where the thermal peeling force was 0.5 N/cm or less was evaluated as A, and a case where the thermal peeling force was more than 0.5 N/cm was evaluated as C. The measurement results are shown in Table 1.

### (Preparation of Drop Test Piece)

The obtained pressure-sensitive adhesive was adhered to a stainless steel plate (SUS304, size: 30 mm × 120 mm). An electrical conductor and an insulator adhered to the pressure-sensitive adhesive, and this was used as a drop test piece. A 100 g stainless steel piece (SUS304) was used as the electrical conductor, and a 100 g resin piece was used as the insulator. An adhesion area between the stainless steel piece and the pressure-sensitive adhesive layer and an adhesion area between the resin piece and the pressure-sensitive adhesive were each 10 mm².

### (Drop Test)

The drop test piece sample was held with an adhesive surface between the electrical conductor and the insulator facing downward (see Fig. 2).

The positive electrode of the direct current machine was attached to the stainless steel plate, the negative electrode of the direct current machine was attached to the electrical conductor and the insulator, and a voltage of 30 V was applied for 30 seconds.

Next, the drop test piece sample was held in an environment of 150°C for 60 seconds with the adhesive surface between the electrical conductor and the insulator facing downward.

A drop test piece sample in which only the electrical conductor dropped when the voltage was applied and the insulator dropped when heated to 150°C was evaluated as A, a drop test piece sample in which only the electrical conductor dropped when the voltage was applied and the insulator did not drop when heated to 150°C was evaluated as B, and others were evaluated as C.

### [Table 1]

**Table 1**

| Raw material name | Detail | Example 1 | Example 2 | Comparative Example 1 |
|---|---|---|---|---|
| Acrylic polymer 1 | BA/MEA/AA | 100 | 100 | 100 |
| AS-110 | Ionic liquid | 5 | 5 | |
| FN-100SD | Thermally expandable filler | 20 | | 20 |
| TETRAD C | Crosslinking agent | 0.3 | 0.3 | 0.3 |
| Peel test | General peeling | 1.5 | 1.6 | 1.5 |
| | Electrical peeling | A, < 0.5 | A, < 0.5 | C, 1.5 |
| | Thermal peeling | A, < 0.5 | C, 1.6 | A, < 0.5 |
| Drop test | - | A | B | C |

Details of the raw materials in Table 1 are as follows.
(Ionic liquid) AS-110
cation: 1-ethyl-3-methylimidazolium cation, anion: bis(fluorosulfonyl)imide anion, product name: "ELEXCEL AS-110", manufactured by DKS Co. Ltd.
(Thermally expandable filler) FN-100SD
Average particle diameter: 10 µm to 20 µm, expansion start temperature: 125°C to 135°C
Product name "Matsumoto Microsphere FN-100SD" manufactured by Matsumoto Yushi-Seiyaku Co., Ltd
(Crosslinking agent) TETRAD C
Epoxy-based crosslinking agent, product name "TETRAD-C" manufactured by MITSUBISHI GAS CHEMICAL COMPANY, INC.

In the peel test using the electrically debondable pressure-sensitive adhesive layers in Examples 1 and 2, the electrical peeling force is less than 0.5 N/cm, which is good, and in the drop test, only the electrical conductor drops at a time when the voltage is applied. Accordingly, it can be seen that, in the case of using the electrically debondable pressure-sensitive adhesive layers in Examples 1 and 2, determining the electrically conductive property of an inspection target and classifying and separating the inspection target are can be performed at the same time. It can also be seen that, in the drop test using the electrically debondable pressure-sensitive adhesive layer in Example 1, the insulator joined to the electrically debondable pressure-sensitive adhesive after the voltage is applied drops when heated to 150°C. On the other hand, in the peel test using the electrically debondable pressure-sensitive adhesive in Comparative Example 1, the electrical peeling force is 1.5 N/cm, which is not lower than the general peeling force, and in the drop test, the electrical conductor drops when the voltage is applied.

Note that, the present application is based on a Japanese Patent Application (No. 2022-125642) filed on August 5, 2022, the contents of which are incorporated herein by reference.

### REFERENCE SIGNS LIST

1: electrically debondable pressure-sensitive adhesive layer
2: fixing member
3: electrical conductor (inspection target)
4: insulator (inspection target)
7: pressure-sensitive adhesive layer
8: electrically conductive layer
10: electrically debondable pressure-sensitive adhesive sheet
12: cutout portion

## Claims

1. An electrical conductivity inspection method, comprising:
joining an inspection target and a fixing member together using an electrically debondable pressure-sensitive adhesive layer capable of joining the inspection target and the fixing member;
applying a voltage to the inspection target and the electrically debondable pressure-sensitive adhesive layer; and
determining an electrically conductive property of the inspection target according to a joining state between the inspection target and the fixing member after the voltage is applied.

2. The electrical conductivity inspection method according to claim 1, wherein it is determined whether the inspection target is an electrical conductor or an insulator based on the electrically conductive property of the inspection target.

3. The electrical conductivity inspection method according to claim 1, wherein it is determined whether the inspection target is a non-defective product or a defective product based on the electrically conductive property of the inspection target.

4. The electrical conductivity inspection method according to claim 1, wherein the inspection target is classified and separated at a same time as the electrically conductive property of the inspection target is determined.

5. The electrical conductivity inspection method according to claim 1, wherein
the fixing member has electrical conductivity, and
a voltage is applied to the electrically debondable pressure-sensitive adhesive layer via the inspection target and the fixing member.

6. The electrical conductivity inspection method according to claim 1, wherein
the electrically debondable pressure-sensitive adhesive layer has a single layer structure,
the fixing member has electrical conductivity, and
a positive electrode for applying a voltage is connected to the fixing member, and a negative electrode for applying a voltage is connected to the inspection target.

7. The electrical conductivity inspection method according to claim 1, wherein a voltage is applied to the electrically debondable pressure-sensitive adhesive layer via the inspection target and an electrically conductive layer, in a state where a pressure-sensitive adhesive layer and an electrically conductive layer are further disposed between the electrically debondable pressure-sensitive adhesive layer and the fixing member.

8. The electrical conductivity inspection method according to claim 7, wherein a positive electrode for applying a voltage is connected to the electrically conductive layer, and a negative electrode for applying a voltage is connected to the inspection target.

9. The electrical conductivity inspection method according to claim 1, wherein the electrically debondable pressure-sensitive adhesive layer contains an electrolyte.

10. The electrical conductivity inspection method according to claim 9, wherein the electrically debondable pressure-sensitive adhesive layer contains an ionic liquid.

11. The electrical conductivity inspection method according to claim 10, wherein an anion in the ionic liquid is at least one anion selected from the group consisting of (FSO₂)₂N⁻, (CF₃SO₂)₂N⁻, (CF₃CF₂SO₂)₂N⁻, (CF₃SO₂)₃C⁻, CH₃COO⁻, CF₃COO⁻, CF₃CF₂CF₂COO⁻, CF₃SO₃⁻, CF₃(CF₂)₃SO₃⁻, Br⁻, AlCl₄⁻, Al₂Cl₇⁻, NO₃⁻, BF₄⁻, PF₆⁻, AsF₆⁻, SbF₆⁻, and F(HF)ₙ⁻ (n represents an integer of 1 or more).

12. A separation method in the electrical conductivity inspection method according to any one of claims 1 to 11, the separation method comprising:
after applying a voltage to the inspection target and the electrically debondable pressure-sensitive adhesive layer,
supplying a predetermined energy other than electricity or a predetermined substance to the electrically debondable pressure-sensitive adhesive layer; and
determining an electrically conductive property of the inspection target, and separating a remaining inspection target joined to the electrically debondable pressure-sensitive adhesive layer after the voltage is applied.

13. The separation method according to claim 12, wherein the remaining inspection target is an insulator.

14. The separation method according to claim 12, wherein heat is supplied as the predetermined energy to the electrically debondable pressure-sensitive adhesive layer.

15. The separation method according to claim 12, wherein an active energy ray is supplied as the predetermined energy to the electrically debondable pressure-sensitive adhesive layer.

16. The separation method according to claim 12,
wherein after applying a voltage to the inspection target and the electrically debondable pressure-sensitive adhesive layer,
the electrically conductive property of the inspection target is determined, and then
the predetermined energy other than electricity or the predetermined substance is supplied to the electrically debondable pressure-sensitive adhesive layer to separate the remaining inspection target.

17. An electrically debondable pressure-sensitive adhesive layer, comprising:
a polymer;
an electrolyte; and
a thermally expandable filler.

18. An electrically debondable pressure-sensitive adhesive layer, which is cured by irradiation with an active energy ray or by heating, comprising:
a polymer; and
an electrolyte.

19. An electrically debondable pressure-sensitive adhesive layer, comprising:
a polymer;
an electrolyte; and
at least one compound selected from the group consisting of a surfactant and a compound having a polyoxyalkylene skeleton.

20. A pressure-sensitive adhesive sheet, comprising:
the electrically debondable pressure-sensitive adhesive layer according to any one of claims 17 to 19.
